# EUROPEAN PATENT SPECIFICATION

(11) **EP 1 340 250 B1**
(45) Date of publication and mention of the grant of the patent: **11.06.2008**
(21) Application number: 01982799.7
(22) Date of filing: 16.11.2001
(51) Int. Cl.: H01L 21/60, H01L 21/66

(54) **BUMP FORMATION METHOD AND BUMP FORMING APPARATUS TO SEMICONDUCTOR WAFER**
HERSTELLUNGSVERFAHREN FÜR HÖCKER UND VORRICHTUNG ZUR ANBRINGUNG VON HÖCKERN AUF EINEM HALBLEITERWAFER
PROCEDE ET APPAREIL PERMETTANT DE PRODUIRE DES BOSSES SUR DES PLAQUETTES SEMI-CONDUCTRICES

(30) Priority: 21.11.2000 JP 2000354448
(43) Date of publication of application: 03.09.2003
(73) Proprietor: MATSUSHITA ELECTRIC INDUSTRIAL CO., LTD, Kadoma-shi, Osaka 571-8501 (JP)
(72) Inventor: NARITA, Shoriki, Hirakata-shi, Osaka 573-0018 (JP); IKEYA, Masahiko, Sakai-shi, Osaka 591-8022 (JP); TSUBOI, Yasutaka, Hirakata-shi, Osaka 573-1146 (JP); MAE, Takaharu, Hirakata-shi, Osaka 573-0018 (JP); KANAYAMA, Shinji, Kashihara-shi, Nara 634-0051 (JP)
(74) Representative: Eisenführ, Speiser & Partner
(86) International application number: PCT/JP2001/010000
(87) International publication number: WO 2002/043137

(56) References cited:
- US-A- 6 070 783
- PATENT ABSTRACTS OF JAPAN vol. 2000, no. 02, 29 February 2000 (2000-02-29) -& JP 11 312703 A (SHIBUYA KOGYO CO LTD), 9 November 1999 (1999-11-09)
- DATABASE WPI Section EI, Week 200102 Derwent Publications Ltd., London, GB; Class U11, AN 2000-335300 XP002215053 & KR 2000 012 116 A (TOSHIBA KK), 25 February 2000 (2000-02-25) -& US 6 284 568 B1 (YAMAMOTO TETSUYA) 4 September 2001 (2001-09-04)
- PATENT ABSTRACTS OF JAPAN vol. 2000, no. 16, 8 May 2001 (2001-05-08) -& JP 2001 015536 A (MATSUSHITA ELECTRIC IND CO LTD), 19 January 2001 (2001-01-19)

## Description

### TECHNICAL FIELD

The present invention relates to a bump formation method in forming bumps onto electrodes of each of ICs formed on a semiconductor wafer, and a bump forming apparatus which carries out the bump formation method.

### BACKGROUND ART

Conventionally in forming bumps onto electrodes of ICs (integrated circuits), bumps have been formed to every one of IC chips, i.e., individual piece cut one by one from a semiconductor wafer. The conventional bump formation method is inferior in productivity because it requires a transfer time for each individual piece to a bump bonding apparatus to form bumps. For shortening the transfer time, an arrangement of transferring the semiconductor wafer to the bump bonding apparatus to form bumps to the ICs on the semiconductor wafer has come to be carried out.

When bumps are to be formed to ICs on the semiconductor wafer, it is necessary to recognize positions of the ICs to form bumps onto electrodes of the ICs. The semiconductor wafer itself is heated to approximately 150-200°C when bumps are formed, and the heat affects the bump bonding apparatus as well, e.g., thermally expands the apparatus or the like. As such, a mark for position recognition formed on each IC has been conventionally imaged by a recognition camera for every IC before the bumps are formed to each IC, thereby correcting the position of the semiconductor wafer.

The semiconductor wafer has, for example, nearly 3000-10000 ICs formed thereon. The larger the number of ICs is, the more it takes time for the position recognition to form bumps. While for instance, 2-4 bumps are formed to each IC, forming one bump takes approximately .60-80msec. On the other hand, recognizing one position recognition mark requires approximately 200-250msec. Since two position recognition marks should be recognized for every IC, the time required for the position recognition is considerably long as compared with the time for forming bumps, with deteriorating a productivity.

JP11312703 discloses a method and apparatus for forming bumps to a semiconductor wafer, wherein blocks of 1-4 adjacent chips are provided with solder bumps simultaneously, by using a specially constructed mounting head in the mounting apparatus. Data on chip arrangement and on defective chip locations are captured using an image recognition camera. From these data, the pattern for using the ball mounting heads for 1-4 chips is calculated.

JP 2001-015536 A, filed on 29 June 1999 and published on 19 January 2001, discloses a method to form a bump at a correct position in an IC pattern on a wafer by searching a first recognition position, registering the obtained position as a data automatically, and executing a mark recognition according to the registered positional data.

### DISCLOSURE OF INVENTION

The present invention is devised to solve the above-described disadvantage and has for its object to provide a bump formation method and a bump forming apparatus to a semiconductor wafer in which a productivity when bumps are formed to the semiconductor wafer is improved in comparison with the conventional art.

In accomplishing this and other objectives, according to a first aspect of the present invention is provided a method for forming bumps to semiconductor wafers as claimed in claim 1.

The bump formation method may be designed so that the method further comprising:
after carrying out the position recognition for a first basic block, forming bumps for the first basic block, whereby the bumps are formed continuously for every IC included in the recognized basic block on a basis of the position recognition; and
when the bump formation operation is shifted from the first basic block to a second basic block among the basic blocks, carrying out the position recognition to the second basic block for forming bumps to ICs included in the second basic block.

The number of the ICs for defining the basic block may be determined further based on at least either a position on the semiconductor wafer where bumps are to be formed, or a time passed after the start of the bump formation to the semiconductor wafer.

After forming bumps for a plurality of the recognized basic blocks, when remaining ICs of the number not satisfying the number of ICs for defining the basic block exist, the bump formation and the position recognition to the remaining ICs may be carried out for each of the remaining ICs or for a combination of a plurality of remaining ICs until bumps are formed to all of the remaining Ics.

The position recognition for the basic block can be carried out by recognizing two marks for position recognition present at diagonal positions of the basic block among marks for position recognition applied to each of ICs at both ends of the basic block.

An inclination of the ICs arranged to the semiconductor wafer is detected before the position recognition operation to the basic block recognizing only one of the two marks for position recognition at the position recognition time to the basic block.

Defective IC information showing a defective IC among the ICs included in the basic block can be detected when bumps are continuously formed to the ICs.

It is possible not to form bumps to the defective ICs on the basis of the defective IC information.

According to a second aspect of the present invention, an apparatus for forming bumps to a semiconductor wafer is provided as claimed in claim 9.

The control device is adapted to obtain the number of ICs for constituting one basic block on the basis of an allowance value for positional deviation between electrodes of the ICs and the bumps to be formed on the electrodes.

The control device is further adaptable to determine the number of ICs for defining the basic block on the basis of at least either a position on the semiconductor wafer where bumps are to be formed or a time passed after the start of the bump formation to the semiconductor wafer.

After forming bumps for a plurality of the recognized basic blocks along the row or column direction, when remaining ICs of the number not satisfying the number of ICs for defining the basic block exist, the control device may carry out the bump formation and the position recognition to the remaining ICs for each of the remaining ICs or for a combination of a plurality of remaining ICs until bumps are formed to all of the remaining ICs.

The control device may carry out the position recognition to the basic block by controlling the recognition device to drive so as to recognize two marks for position recognition among marks for position recognition applied to each IC of the basic block.

The bump forming apparatus may be provided with;
a wafer turning member onto which the semiconductor wafer to be subjected to bump bonding is loaded and which is turned in a circumferential direction of the loaded semiconductor wafer; and
a turning device for turning the wafer turning member in the circumferential direction by driving control by the control device,
wherein the control device detects an inclination of the ICs arranged on the semiconductor wafer before the recognition operation to the basic block by controlling to drive the recognition device, further corrects the inclination by controlling the turning device on the basis of the detected inclination value of the ICs to turn the semiconductor wafer loaded on the wafer turning member, and also controls the recognition device to drive at the position recognition time to the basic block so as to recognize only one of the two marks for position recognition and eliminate the detection of the inclination of the ICs included in the basic block.

The control device can control the recognition device to drive to detect defective IC information showing a defective IC among the ICs arranged on the semiconductor wafer.

The control device may control operation of the bump bonding apparatus on the basis of the defective IC information so as not to form bumps onto the defective ICs.

According to the bump formation method of the first aspect and the bump forming apparatus of the second aspect of the present invention as described above, there are provided the bump bonding apparatus, the recognition device, and the control device, and the ICs formed on the semiconductor wafer are divided to basic blocks. The bump formation is continuously carried out to the ICs included in the basic block. The position recognition for the other basic block is conducted only when the bump formation is changed from one basic block to the other basic block. As compared with the conventional art wherein the position recognition operation is carried out every time bumps are formed to each IC, the number of times of the recognition is greatly reduced and the productivity can be improved.

The position between the electrode and the bump can be always kept proper by determining the number of ICs for defining the above basic block in accordance with at least one of a position on the semiconductor wafer where the bump formation is carried out and a time passed after the start of the bump formation.

Unless all ICs on the semiconductor wafer can be divided to blocks by using only the basic block, the bump formation is carried out for each IC of the remaining ICs or for each combination of a plurality of ICs and one IC. Bumps can be formed to all ICs while the number of times of the recognition is reduced thereby improving the productivity in comparison with the conventional art.

Since a distance between two marks for position recognition is increased by so arranging as to recognize the position recognition marks at diagonal positions in the basic block, the inclination of the basic block can be obtained with a higher accuracy.

Moreover, if the inclination of ICs is detected in advance before the bump formation, it is enough at the bump formation time to recognize one of two marks for position recognition of the basic block. The number of times of the recognition can be further reduced, so that the productivity can be improved more.

In addition, detecting the bad mark at the bump formation time saves the bump formation to ICs with the bad marks. Therefore, a time to be spent for forming bumps to the ICs which is unnecessary to the ICs can be cut and the productivity can be furthermore improved.

### BRIEF DESCRIPTION OF DRAWINGS

These and other aspects and features of the present invention will become clear from the following description taken in conjunction with the preferred embodiment thereof with reference to the accompanying drawings, in which:
Fig. 1 is a flow chart showing operations of a bump formation method in the preferred embodiment of the present invention;
Fig. 2 is a flow chart showing operations of the bump formation method in the preferred embodiment of the present invention;
Fig. 3 is a flow chart showing an operation of detecting a position and an inclination of ICs of a semiconductor wafer which can be carried out before the bump formation operation in Figs. 1 and 2;
Fig. 4 is a diagram for explaining a basic block formed in the bump formation operation of Figs. 1 and 2;
Fig. 5 is an enlarged view of one basic block in Fig. 4;
Fig. 6 is a diagram showing a different form of the basic block of Fig. 4 and a form of a bad mark;
Fig. 7 is a diagram for explaining changing the number of ICs for defining the basic block in accordance with a bump formation position on the semiconductor wafer for the basic block of Fig. 4;
Fig. 8 is a diagram for explaining changing the number of ICs for defining the basic block for the basic block of Fig. 4;
Fig. 9 is a diagram of a state in which a sensor for measuring a temperature above the semiconductor wafer, or the like is installed to a horn part and an image pickup camera so as to change the number of ICs for defining the basic block;
Fig. 10 is a diagram showing a state with a bump formed on an electrode;
Fig. 11 is a diagram explanatory of a mark for position correction which is applied to the IC;
Fig. 12 is a flow chart for explaining the detailed operation of the bad mark detection shown in Fig. 1;
Fig. 13 is a flow chart for explaining the detailed operation of the bad mark detection shown in Fig. 1;
Fig. 14 is a diagram for explaining remaining ICs except the basic blocks;
Fig. 15 is a diagram of the case where a block for remainder is defined by the remaining ICs of Fig. 14;
Fig. 16 is a diagram of the case where blocks for remainder are defined by the remaining ICs of Fig. 14;
Fig. 17 is a diagram showing a view field, a maximum deviation area, etc. of the image pickup camera for explaining the search operation carried out in step 32 in Fig. 3;
Fig. 18 is a flow chart for explaining one search operation carried out in step 32 in Fig. 3;
Fig. 19 is a flow chart for explaining another search operation carried out in step 32 in Fig. 3;
Fig. 20 is a flow chart for explaining a different search operation carried out in step 32 in Fig. 3;
Fig. 21 is a diagram for explaining the search operation in Fig. 18;
Fig. 22 is a diagram for explaining a quantity of move of the view field in the search operation of Fig. 18;
Fig. 23 is a diagram for explaining the search operation of Fig. 19;
Fig. 24 is a diagram for explaining the search operation of Fig. 20;
Fig. 25 is a diagram for explaining the search operation of Fig. 20;
Fig. 26 is a diagram of an example of a shape of a detection point for inclination correction in the search operation of Fig. 20;
Fig. 27 is a diagram of an example of another shape of the detection point for inclination correction in the search operation of Fig. 20;
Fig. 28 is a diagram of one example of a second detection point for recognition in step 4 of Fig. 1;
Fig. 29 is a perspective view of a bump forming apparatus in the embodiment for executing the bump formation method of Fig. 1; and
Fig. 30 is a perspective view of a heating device for bonding shown in Fig. 29.

### BEST MODE FOR CARRYING OUT THE INVENTION

A bump formation method to a semiconductor wafer, and a bump forming apparatus to a semiconductor wafer which carries out the bump formation method according to the preferred embodiment of the present invention will be described hereinbelow with reference to the drawings in which like parts are designated by like reference numerals. All of ICs (integrated circuits) formed on the semiconductor wafer are equal in size and in shape. A form of forming ICs onto the semiconductor wafer is not specified and can be either forming ICs to an entire face including a circumferential edge part of the semiconductor wafer or refraining from forming ICs to a marginal part when the marginal part is provided to the circumferential edge part.

In order to accomplish the above-described objective of improving the productivity in forming bumps to the semiconductor wafer as compared with the conventional art, roughly, a first to a third points below are intended in the bump formation method to the semiconductor wafer of the embodiment.

First, one block is defined imaginarily of a plurality of ICs (integrated circuits) formed on the semiconductor wafer. Position recognition is carried out in every unit of block by recognizing two marks for position recognition included in each block, and position recognition is omitted when bumps are formed to each of ICs included in the block. The number of times of the recognition is thus reduced in comparison with the conventional art, so that the productivity is improved.

Secondly, the recognition to two marks for position recognition in the block is reduced to one mark, thereby improving the productivity more.

Thirdly, the presence/absence of bad marks applied to ICs on the semiconductor wafer, the ICs not functioning as ICs, i.e., defective ICs is determined, so that bumps are not formed to the defective ICs. Thus the productivity is much further improved.

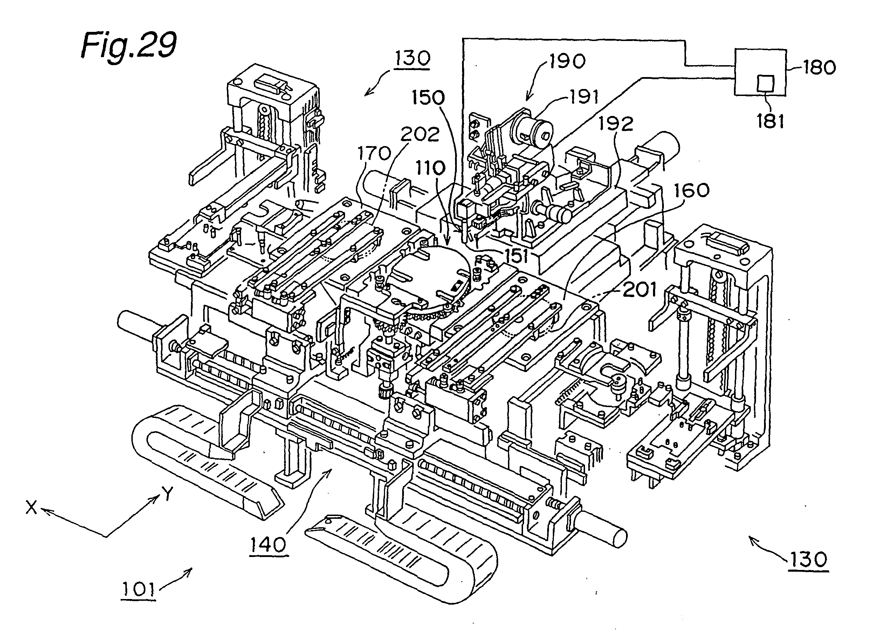

The bump forming apparatus to a semiconductor wafer which carries out the above bump formation method to the semiconductor wafer is schematically shown in Fig. 29. The bump forming apparatus 101 comprises one heating device 110 for bump bonding, a recognition device 150, a control device 180, and one bump forming head 190 corresponding to one example of a bump bonding apparatus. The bump forming apparatus preferably includes carriers 130, transfer devices 140 arranged respectively to the carry-in side and the carry-out side, a preheating device 160, and a postheating device 170.

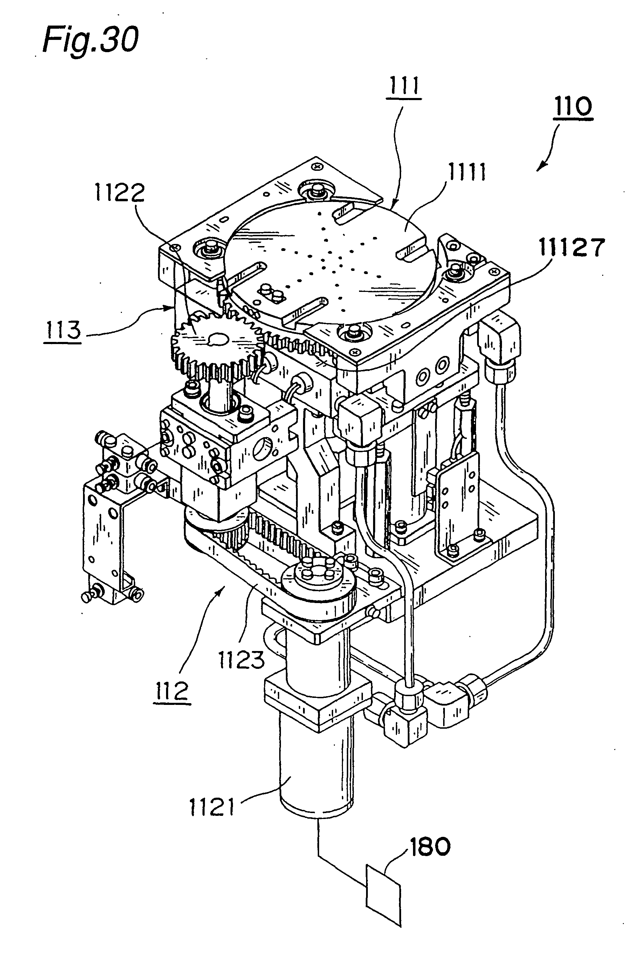

The heating device 110 for bump bonding is roughly comprised of, as shown in Fig. 30, a wafer turning member 111, a turning device 112, and a wafer heater 113. The heating device 110 holds onto the wafer turning member 111 a semiconductor wafer 201 without bumps formed yet which is to be subjected to bump bonding and heats the loaded semiconductor wafer 201 by the wafer heater 113 to a bump bonding temperature which is approximately 150°C in the embodiment. A semiconductor wafer after bumps are formed by the bump forming head 190 to electrodes of ICs on the semiconductor wafer 201 will be denoted as a bump-formed wafer 202.

The wafer turning member 111 has a metallic disc wafer stage 1111 of a larger diameter than a diameter of the semiconductor wafer 201 for loading the semiconductor wafer 201 thereon, and a metallic disc turntable 1112 of a nearly equal size as a size of the wafer stage 1111 having threads 11127 formed to the entire circumference to be meshed with a gear 1122 to be described later of the turning device 112.

The turning device 112 is a device for turning the wafer turning member 111 with the semiconductor wafer 201 loaded thereon in a circumferential direction of the semiconductor wafer 201. In the present embodiment, the turning device 112 has a driving source 1121 of a servo motor which is controlled by the control device 180 to drive, the gear 1122 to be meshed with the threads 11127 of the turntable 1112, and a rotational force transmission mechanism 1123 for transmitting a driving force generated by the driving source 1121 to the gear 1122 thereby rotating the gear 1122 while preventing heat of the turntable 1112 from being conducted to the driving source 1121. Although a timing belt is used as the rotational force transmission mechanism 1123 in the embodiment, the transmission mechanism is not limited to this structure.

As described hereinabove, since the semiconductor wafer 201 is turned via the driving source 1121, the rotational force transmission mechanism 1123, the gear 1122, threads 11127 of the turntable 1122, and the wafer stage 1111, a turning angle of the semiconductor wafer is controlled by the control device 180, enabling the semiconductor wafer 201 to be turned at any angle.

The recognition camera 150 with an image pickup camera 151 detects a position of the IC and an inclination to a reference line of the IC on the basis of image pickup information of the image pickup camera 151. The image pickup camera 151 which is freely movable in row and column directions above the semiconductor wafer 201 picks up images of marks 224, 2232-2234 for detection on the semiconductor wafer. The recognition device 150 is connected to the control device 180. The control device 180 controls to drive the turning device 112 on the basis of the detected inclination information thereby controlling a quantity of the turn of the wafer turning member 111.

The bump forming head 190 is a device for forming bumps onto the electrodes of the ICs on the semiconductor wafer 201 loaded on the wafer turning member 111 of the heating device 110 and heated to the bump bonding temperature. The bump forming head 190 includes, in addition to a wire supply part 191 for supplying a gold wire to be a material for bump, a bump formation part for melting the gold wire to form a melted ball and pressing the melted ball to the electrode, an ultrasonic wave generation part for acting ultrasonic waves to the bump at the pressing time, etc. The thus-constituted bump forming head 190 is attached on an X, Y table 192 which has, e.g., a ball screw structure and is movable in mutually orthogonal X and Y directions on a plane. The bump forming head 190 is moved in the X, Y directions by the X, Y table 122 to be able to form bumps to electrodes of each IC of the fixed semiconductor wafer 201.

The carriers 130 are devices for taking out the semiconductor wafer 201 from a first storage container in which the semiconductor wafer 201 is stored and for transferring to store the bump-formed wafer 202 to a second storage container which is to store the bump-formed wafer 202.

One of the transfer devices 140 receives the semiconductor wafer 201 from the carrier 130, then transferring the wafer 201 to the preheating device 160 and moreover transfers the wafer 201 from the preheating device 160 to the heating device 110 for bump bonding. The other transfer device 140 transfers the bump-formed wafer 202 on the wafer stage 1111 to the postheating device 170 and delivers the wafer 202 from the postheating device 170 to the carrier 130.

The preheating device 160 is a device for raising a temperature of the semiconductor wafer 201 loaded thereon from a room temperature to the bump bonding temperature at which bumps are formed by the heating device 110.

The postheating device 170 is a device for gradually decreasing a temperature of the bump-formed wafer 202 loaded thereon from the bump bonding temperature to the vicinity of the room temperature.

The control device 180 controls to drive each part constituting the bump forming apparatus 101 of the above constitution, thereby controlling the bump formation method including the aforementioned first-third points to be described in detail below.

The bump formation method carried out by the above-constituted bump forming apparatus 101 will be depicted hereinbelow. The bump formation method is executed by driving control by the control device 180. Processing and transfer operations to the semiconductor wafer 201 from the first storage container to the heating device 110, and processing and transfer operations to the bump-formed wafer 202 from the heating device 110 to the second storage container after bumps are formed to the semiconductor wafer 201 are omitted from the following description. The operation up to the end of the bump formation after the semiconductor wafer 201 is loaded to the wafer stage 1111 of the heating device 110 will be detailed below.

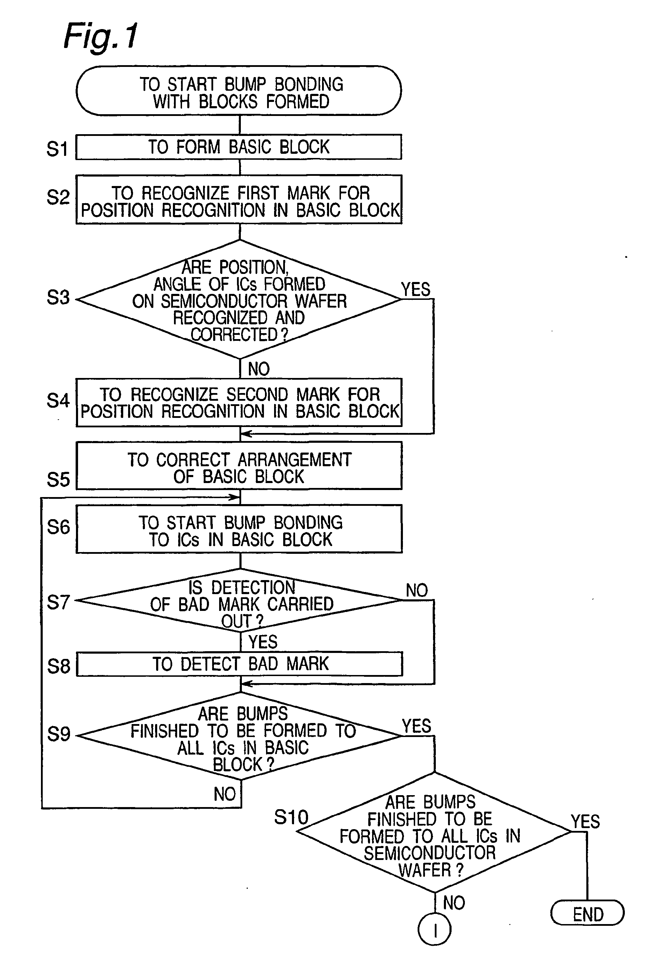

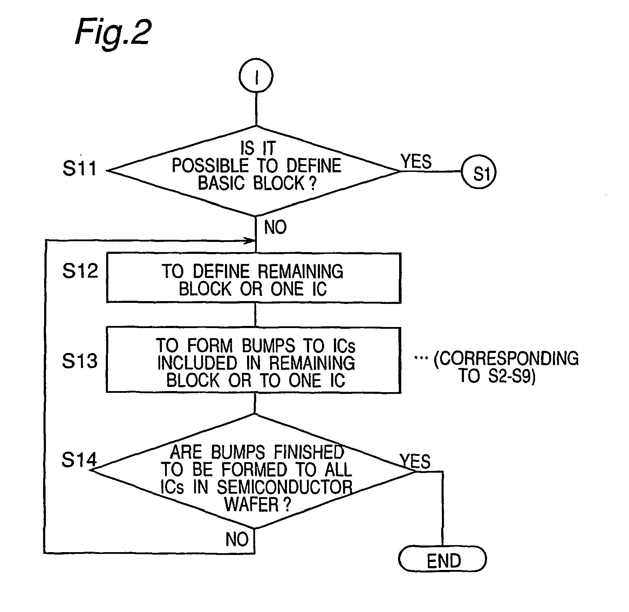

The bump formation method is briefly indicated in Figs. 1-3, which will be discussed along each step (designated by "S" in the drawings).

An allowable range of a positional deviation of the bumps to the electrodes when bumps are formed to the electrodes of the IC is conventionally ±5µm. The value of the allowable range is determined while the thermal expansion or the like of the image pickup camera 151 and the bump forming head 190 because of the heat heating the semiconductor wafer 201 for bump formation is taken into account. The allowable range of the above ±5µm is a range which can be satisfied even when bumps are formed onto electrodes on a single IC in a size of 5-6mm square. Therefore, with respect to a single IC in a size of 0.5mm or 0.35mm square in these days, the allowable range can be fulfilled even if bumps are continuously formed to, e.g, approximately 10 of the ICs without executing position recognition.

Therefore, according to the present embodiment, in step 1, a basic block is defined imaginarily having a plurality of ICs adjacent each other in a row or column direction, or in row and column directions among ICs arranged in a grid pattern on the semiconductor wafer 201 to be subjected to bump bonding. Position recognition is executed with respect to the basic block. Then bumps are continuously formed to all ICs included in the basic block. So, the bump forming operation is carried out every basic block. When the bump formation is moved from one basic block to another basic block among the basic blocks, the position recognition is executed with respect to the another basic block to form bumps to the ICs included in the another basic block.

By adopting this method, the number of times of the IC position recognition can be reduced in comparison with the conventional art in which the recognition operation is carried out for every IC. Thus, the productivity in forming bumps to the semiconductor wafer can be improved as compared with the conventional art.

The number of ICs for defining the above basic block is a value that, when the bumps are continuously formed onto the electrodes of all ICs in the basic block without executing position recognition for each IC, all of the positional deviations between the electrodes and bumps thereon is kept within the allowable range. Conversely, a single basic block is defined by such number of ICs.

The number of rows, columns of ICs for forming the basic block is preliminarily stored to a memory part 181 in the control device 180.

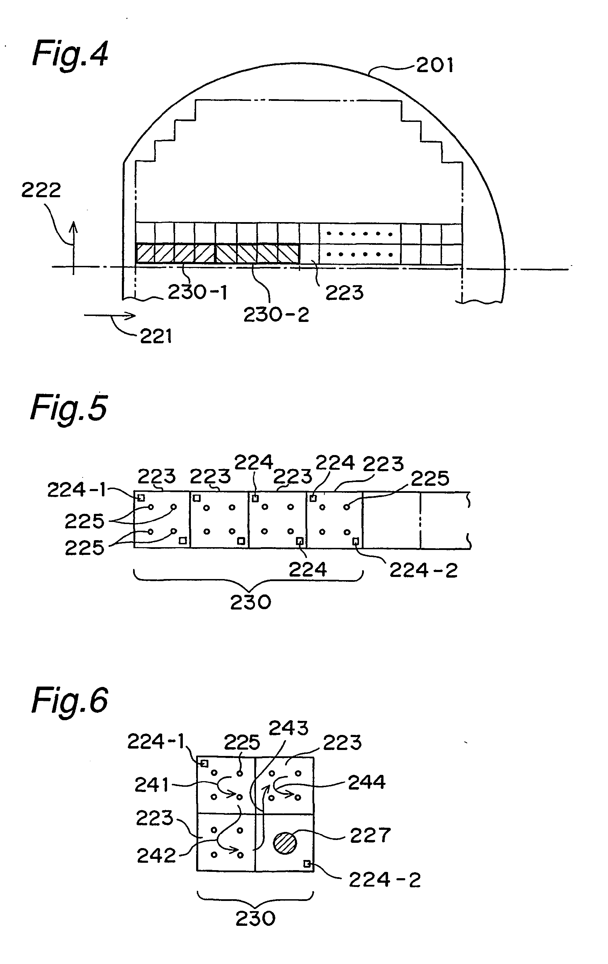

The operation of forming the basic block will be described below with reference to the drawings. As shown in Fig. 4, the semiconductor wafer 201 loaded on the wafer stage 1111 and sucked to the wafer stage 1111 in the embodiment has a plurality of ICs 223 arranged in the grid pattern along a row direction 221 and a column direction 222. The control device 180 forms basic blocks 230 starting from the IC 223 where the bump formation is to be started in accordance with the stored number of rows and columns of ICs for defining the basic block. For example as shown in Fig. 5, the control device 180 forms basic blocks 230-1, 230-2, ..., of, e.g., one row and four columns from, e.g., a circumferential edge portion of a central part of the semiconductor wafer 201.

The position where the bump formation is to be started is not restricted to the aforementioned position. Also the number of rows and columns of ICs for defining the basic block is not limited to the above, and the basic block may be defined, for instance, of a plurality of rows and a plurality of columns as shown in Fig. 6 or may be defined of a plurality of rows and one column.

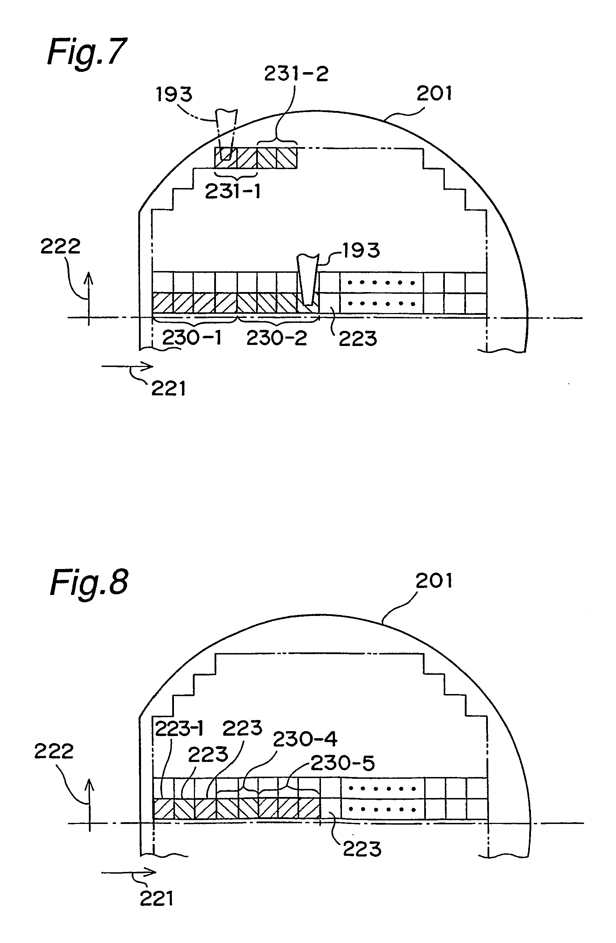

The number of rows and columns of ICs in the basic block 230 is not limited to a constant value and can be changed. For example, while the ultrasonic wave generation part of the bump forming head 190 is partly positioned above the wafer stage 1111 at the circumferential edge portion of the semiconductor wafer 201, the other part is positioned out of the wafer stage 1111 and consequently the thermal effect to the ultrasonic wave generation part becomes uneven in some cases because the wafer stage 1111 is heated to form bumps as described earlier. As such, for a position, e.g., the circumferential edge portion of the semiconductor wafer 201 where the thermal effect is not even to, e.g., a horn part 193 of the ultrasonic wave generation part of the bump forming head 190 as shown in Fig. 7, the basic block can be defined by one row and two columns like basic blocks 231-1, 231-2. On the other hand, for a position, e.g., the central portion of the semiconductor wafer 201 where the thermal effect is relatively even, the basic block can be defined by one row and four columns as in basic blocks 230-1, 230-2.

As indicated in Fig. 8, in the case where the bump formation is started from, e.g., an IC 223-1, basic blocks 230 may not be formed while a lapse of time from the start of bump formation is short, and basic blocks 230 are formed as the passed time is longer. That is, the number of rows and columns of ICs may be increased to a certain constant value such as, e.g., in a basic block 230-4 of one row and two columns, a basic block 230-5 of one row and three columns.

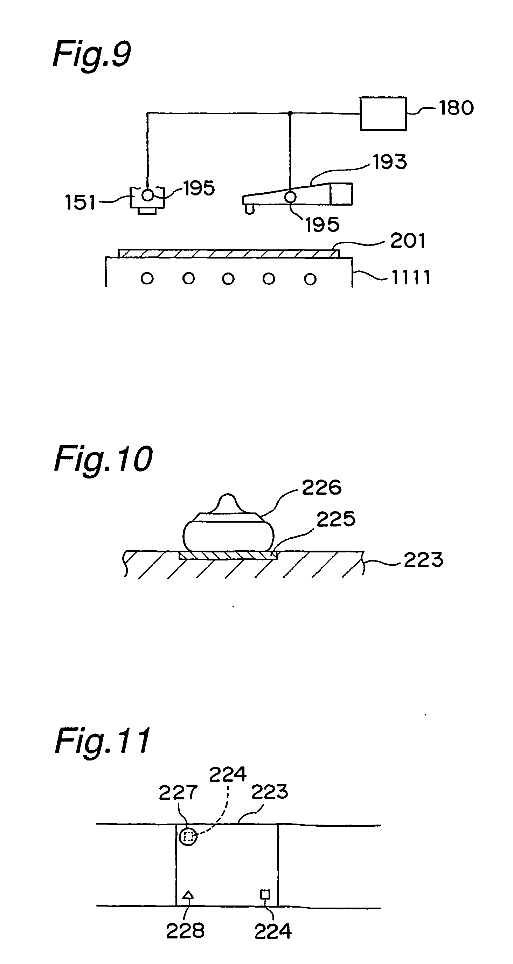

A temperature sensor of, e.g., a thermocouple or strain sensor 195 may be attached to at least either the horn part 193 of the bump forming head 190 or the image pickup camera 151 as shown in Fig. 9, so that the control device 180 may determine the number of rows and columns of ICs in the basic block 230 on the basis of output information of the sensor 195.

Alternatively, the number of rows and columns of ICs of the basic block 230 may be determined by a position of the ICs 223 on the semiconductor wafer 201 where bumps are to be formed, or the number of rows and columns of ICs may be forcibly determined or changed.

Defining the basic block 230 in the control device 180 is carried out in a manner as follows in the embodiment. As similar to the conventional art, the control device 180 has a program for bump formation stored in the memory part 181 for each of all ICs 223 formed to the semiconductor wafer 201. Position information of every two marks 224 for position recognition present in each IC 223 indicating an arrangement position of the IC 223, position information of each electrode 225 present in each IC 223, and information on a bump formation order to the electrodes 225 present in one IC 223, etc. are described in the program. The control device 180, with utilizing the program for bump formation, executes the bump formation operation while taking a region of the above-determined number of rows and columns of ICs as the basic block 230.

In other words, with respect to one unit defining one basic block 230, forming a fresh program which represents position information of the basic block, position information of electrodes in the basic block, and the like is not executed. The existing program for bump formation is utilized to form bumps. The need of correcting or reforming the program is accordingly eliminated even if the number of rows and columns of ICs of the basic block 230 is changed, thereby facilitating adaptation with a high degree of freedom.

After the control device 180 determines the basic blocks 230 as above, in step 2, position recognition is carried out for the basic block 230 including ICs 223 to which bumps are to be formed. Each of the ICs 223 constituting the basic block 230 has two marks 224 for position recognition as mentioned above. In the embodiment, first, one of two marks 224 for position recognition corresponding to diagonal positions of the basic block 230 among marks 224 of the ICs 223 present at both ends of the basic block 230 is imaged by the image pickup camera 151 of the recognition device 150. For instance in the basic block 230 shown in Fig. 5, for example a first mark 224-1 for position recognition of two marks 224-1 and 224-2 for position recognition corresponding to the diagonal positions is imaged.

In next step 3, it is determined whether or not information for position correction of the ICs 223 is already obtained and an inclination of the ICs 223 is already corrected when the semiconductor wafer 201 is placed on the wafer stage 1111. Although the operation of obtaining the information for position correction for the ICs 223 and correcting the inclination of the ICs 223 which are determined in step 3 will be described in detail later, in the case where the ICs 223 are already corrected particularly in inclination, operation in next step 4 can be eliminated. Accordingly the number of times of the recognition operation is reduced and the productivity is improved. On the other hand, if the inclination is not corrected yet, the step moves to next step 4.

In step 4, the image pickup camera 151 of the recognition device 150 images the remaining second mark 224-2 for position recognition of the two position recognition marks 224-1 and 224-2. Based on the position information of the two position recognition marks 224-1 and 224-2, the control device 180 obtains a position and an inclination of the basic block 230 according to a known arithmetic method.

In the present embodiment, position recognition marks 224-1 and 224-2 present at both ends of the basic block 230 are employed in steps 2 and 4. Although using the position recognition marks 224 present at diagonal positions is preferred particularly from a viewpoint of obtaining the inclination information of the basic block 230, the position recognition mark 224 to be used is not limited to the position recognition marks 224-1 and 224-2 present at both ends of the basic block 230 and any different two points can be selected to be the position recognition mark.

In succeeding step 5, on the basis of the above inclination information of the basic block 230 which is obtained in step 2 or in steps 2 and 4, the control device 180 controls to drive the turning device 112 of the heating device 110 to turn the wafer stage 1111 so that the IC 223 becomes parallel to a reference line, e.g., the X direction or Y direction. At this time, the wafer stage 1111 can be turned by any angle because the present embodiment adopts the constitution including the wafer turning member 111 and the turning device 112 as described before.

The control device 180 controls a quantity of the move of the X, Y table 192 of the bump forming head 190 based on the above position information of the basic block 230 when bumps are to be formed.

In following step 6, the control device 180 controls to drive the bump forming head 190 based on the program for bump formation with respect to the semiconductor wafer 201 loaded and sucked onto the wafer stage 1111 and also heated to the bonding temperature, thereby forming bumps 226 as shown in Fig. 10 onto each of electrodes 225 of the ICs 223 included in the basic block 230.

Bumps are continuously formed in the bump formation operation without carrying out position recognition of IC 223 to all ICs 223 included in one basic block 230. Without the position recognition operation executed for each of the ICs 223 according to the embodiment, the number of times of the position recognition is reduced in comparison with the conventional art, thus enabling the productivity to be improved.

Step 7 is carried out together with the bump formation after the bumps 226 are started to be formed.

In the aforementioned step 7, it is determined whether or not a bad mark applied to the ICs 223 included in the basic block 230 to which the bump formation is being formed is to be detected. The bad mark is applied, e.g., at an inspection after a wiring pattern recognition process before the bumps are formed onto the electrodes 225, which is a mark for indicating a defective IC not functioning as an IC. The bad mark is applied to a nearly central part of the IC 223 as shown by a numeral 227 in Fig. 6 or applied over-lapping with one of the two position recognition marks 224 of the IC 223 as shown in Fig. 11. The bad mark is formed to any position within the IC 223. In the case where the bad mark 227 is formed overlap-ping with the position recognition mark 224, it becomes impossible to recognize the position recognition mark 224 having the bad mark 227. Therefore, with the utilization of the nonrecognition, it can be determined so that the IC 223 or basic block 230 is a defective IC or defective block if the position recognition mark 224 cannot be recognized. However, bad marks 227 might be included in other ICs 223 in the basic block 230 in some cases even when the bad mark 227 is not detected at the position recognition mark 224 of the basic block 230. Therefore, the detection for the bad mark 227 is preferably carried out for other ICs 223 as well.

The presence/absence of the bad mark is detected by imaging the ICs 223 by the image pickup camera 151 in the embodiment.

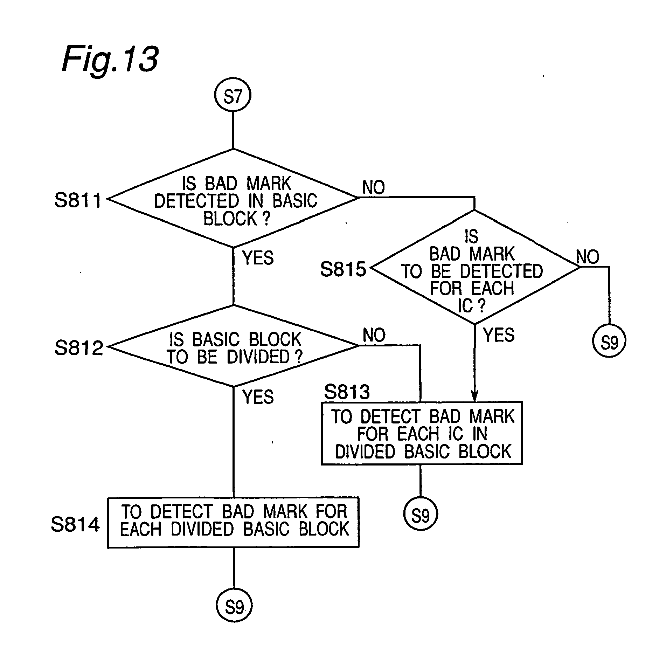

In the case where the bad mark 227 is applied to one of two position recognition marks 224-1 and 224-2 to be recognized in the basic block 230 and when the bad mark is actually detected, the position recognition with respect to other basic blocks 230 may be started without forming bumps to the subject basic block 230. However, some of the ICs 223 constituting the basic block 230 which is detected to include the bad mark 227 may be good ICs. In order not to waste good ICs, even if one of the position recognition marks 224-1 and 224-2 imaged for the position recognition of the basic block 230 has the bad mark 227, it is preferable to make determination for each of the ICs 223 included in the basic block 230 whether or not the bad mark 227 is applied thereto, as shown in steps 811-813 in Fig. 13.

Supposed that the basic block 230 is defined by, e.g., six ICs 223 of one row and six columns and when the basic block 230 is detected through the position recognition to include the bad mark 227, it may be so arranged as shown in step 814 of Fig. 13 that the presence/absence of the bad mark 227 is recognized for each of divided basic blocks which are obtained by more finely dividing the subject basic block 230 in place of immediately determining the presence/absence of the bad mark 227 for each IC 223 in the basic block as above. If the bad mark 227 is detected in the divided basic block, the presence/absence of the bad mark 227 is recognized for a next divided basic block or next basic block. The operation of step 814 is effective when two position recognition marks 224 are to be recognized for the basic block 230.

Alternatively, the IC 223 detected to include the bad mark 227 may be separated from the basic block 230 so as not to form bumps to the subject IC 223 with the bad mark, and the position recognition of the subject basic block 230 may be executed with a next, e.g., adjoining IC 223.

The following description of the bad mark detection operation exemplifies the case of determining the presence/absence of the bad mark 227 for every one of all ICs 223 in the basic block 230.

When the bad mark is to be detected, the step moves to next step 8, where the bad mark is detected. The control device 180 stops forming bumps to the IC 223 determined to have the bad mark and moves to detect the bad mark for a next IC 223. A time required for forming bumps to the IC 223 which is useless to the IC 223 with the bad mark can be cut by this operation and the productivity can be improved.

On the other hand, when the bad mark is not to be detected, the step goes to step 9 while bumps are formed to all ICs 223 included in the basic block 230.

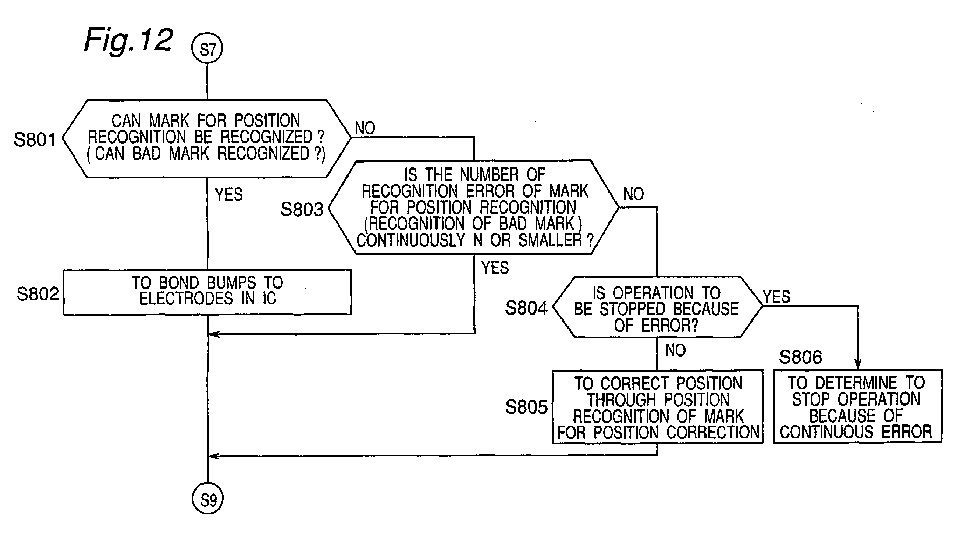

When the inclination correction to the semiconductor wafer 201 is already executed which is determined in the above-described step 3 and when the bad mark 227 is formed overlapping with one position recognition mark 224, an operation to be described below may be carried out in step 8 with reference to Fig. 12. It becomes impossible to recognize the position recognition mark 224 when the bad mark 227 is formed overlapping with one of the position recognition marks 224, and eventually it becomes impossible to recognize the position of the IC 223 or basic block 230. For avoiding this, with respect to each IC 223, it is necessary to treat, in addition to the position recognition mark 224, an arbitrary point in a circuit pattern on the IC 223 as a mark 228 for position correction to substitute for the position recognition mark 224 as shown in Fig. 11. The mark 228 for position correction is illustrated to be triangular in Fig. 11 for the sake of convenience. Although the mark 228 for position correction may be formed separately to the IC 223, it is simpler and preferable to register the arbitrary point in the circuit pattern of the IC 223 as above into a program as the position correction mark 228.

Regarding Fig. 12 showing the operation of step 8 in detail, in step 801, the control device 180 controls to drive the recognition device 150 to recognize one position recognition mark 224 of the IC 223 included in the basic block 230 as described earlier. When the position recognition mark 224 can be recognized, in other words, when the IC 223 includes no bad mark, the step goes to step 802, in which the control device 180 controls to drive the bump forming head 190 to form bumps 226 to electrodes 225 of the IC 223.

Meanwhile, when the position recognition mark 224 cannot be recognized in step 801, that is, when the IC 223 has the bad mark, the step moves to step 803 and the control device 180 determines whether or not the number of counts that the position recognition mark 224 cannot be recognized is n or less. In other words, how many defective ICs are continuously detected is determined.

In some cases, the position of a good IC cannot be determined even if the good IC is detected after many defective ICs are detected, or a quantity of the positional deviation between the electrode and the bump exceeds the allowable range even when the bumps are formed to the electrodes of the good IC. Therefore, the above number n is the number of ICs 223 in which at least the quantity of the positional deviation between the electrode 225 and the bump 226 of the IC 223 is accommodated within the allowable range. The number n is set to the control device 180 in advance.

When the number of counts that the position recognition mark 224 cannot be recognized is not larger than the n in step 803, the step shifts to step 9. On the other hand, when the number of counts exceeds the above n, it is highly possible that the quantity of the positional deviation between the electrode 225 and the bump 226 of the IC 223 exceeds the allowable range as mentioned above. Then it is determined in step 804 whether or not the operation is to be stopped because of an error, and the operation is stopped in step 806 if it is so determined. Oppositely, if the operation is not to be stopped, the step goes to step 805 and the control device 180 controls to operate the recognition device 150 thereby recognizing the position correction mark 228 and confirming the present position to correct the position. The step then moves to step 9.

Although it is so adapted in the embodiment as to actually detect the presence/absence of the bad mark 227 in steps 8, 801-806, 811-814, the bump formation may be executed on the basis of, e.g., position data of defective ICs in the already processed semiconductor wafer. In this case, since position data of the defective ICs is hardly equal in all semiconductor wafers 201, it is preferable to detect the position of the bad mark 227 again and update the position information of the bad mark 227 for every constant number of wafers. The above constant number can be appropriately set by a manufacturer of the semiconductor wafer 201, a production lot of the semiconductor wafer, etc.

Even when the bad mark 227 is not to be detected in step 811, step 815 may be provided to determine whether or not the bad mark 227 is to be detected for each of ICs 223 in the basic block 230. The step goes to step 9 when the detection is not to be carried out, whereas the step goes to step 813 when the detection is to be carried out.

In next step 9, it is determined whether or not bumps are already formed to all ICs 223 included in the basic block 230 subjected to the bump formation. The step returns to step 6 if an IC 223 without the bumps formed is present. The step advances to step 10 when bumps 226 are formed to all ICs 223 in the basic block 230.

An example of the bump formation order to all ICs 223 included in the basic block 230 is indicated in Fig. 6. The basic block 230 is defined by ICs 233 of two rows and two columns in Fig. 6. Bumps 226 are formed to each of electrodes 225 in the order designated by arrows 241-244. As above, the bump formation order is preferably such that the bump formation is completed for every IC 223 included in the basic block 230 to almost uniform a bump formation state in one IC.

It is determined in step 10 whether or not bumps 226 are formed to all ICs 223 in the semiconductor wafer 201. The aforementioned all ICs 223 mean all good ICs in the case of not forming bumps to defective ICs as referred to above.

The bump formation process to the semiconductor wafer 201 is terminated when bumps are formed to all ICs 223. On the other hand, the step goes to next step 11 if there are ICs 223 without the bumps formed yet.

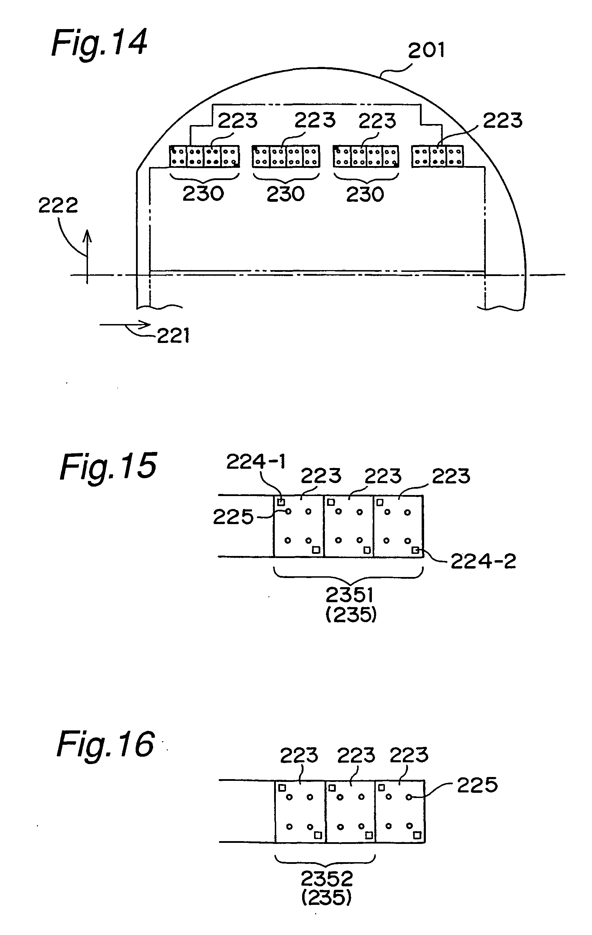

The process related to the bump formation is completed to one basic block 230 through the operations up to the above step 9. It is determined in step 11 whether or not further basic blocks 230 can be formed of the ICs 223 in the semiconductor wafer 201. Specifically, supposed that a certain row in the semiconductor wafer 201 includes, e.g., 15 ICs 223 as shown in Fig. 14, three basic blocks 230, e.g., each of one row and four columns can be formed and three ICs 223 are left in the row. The remaining three ICs 223 cannot form the basic block 230 of one row and four columns. That is, the basic block cannot always be defined by the set number of rows and columns of ICs.

When the basic block 230 can be formed of the set number of rows and columns of ICs, step 11 returns to step 1 to carry out the process related to the bump formation as above to the defined basic blocks 230. However, if there are ICs 223 of the number not satisfying the set number of rows and columns and consequently the basic block 230 cannot be formed, step 11 moves to next step 12. In the semiconductor wafer 201, a bonding boundary representing a region where bumps 226 can be formed is arranged along circumferential edge parts of the ICs 223 for the formed ICs 223 on the wafer 201. The above number not satisfying the set number of rows and columns is a number which is obtained with respect to the ICs 223 included within the region delimited by the bonding boundary. ICs of the number not satisfying the number of rows and columns for constituting the basic block 230 in a certain row or column, or in certain row and column will be denoted as remaining ICs.

The control device 180 determines in step 12 whether to carry out the process related to the bump formation by forming the ICs 223 of the number not satisfying the set number of rows and columns into blocks, to execute the process related to the bump formation for every one of the ICs 223, or to execute the process related to the bump formation by a combination of the above. Specifically with reference to the above example, with respect to the remaining ICs 223, one block 2351 for remainder is formed with all of the remaining ICs 223, namely, with the above three ICs 223 in this example as shown in Fig. 15, and then the process related to the bump formation is carried out to the block 2351 for remainder. Alternatively, one block 2352 for remainder is formed with two ICs 223 as shown in Fig. 16 and then the process related to the bump formation is carried out to the block 2352, or the process related to the bump formation is carried out individually to each of the remaining ICs 223.

Whether to define the block 235 for remainder with respect to the remaining ICs 223, or to process the remaining ICs 223 one by one is preliminarily programmed to the control device 180. In the case of defining the block 235 for remainder, the number of rows and columns of ICs 223 for defining the block 235 for remainder with respect to the remaining ICs 223 may be automatically determined by the control device 180 or may be set beforehand.

In next step 13, the process related to the bump formation which corresponds to operations of the above steps 2-9 is executed either with respect to the block 235 for remainder or each of the remaining ICs 223, or with respect to the block 235 for remainder and each of the remaining ICs 223, which are constituted in step 12.

It is determined in next step 14 whether or not bumps 226 are completely formed to all ICs 223 in the semiconductor wafer 201. If there are ICs 223 having bumps not formed, the step returns to the foregoing step 12. On the contrary, when all ICs 223 have bumps 226 completely formed thereto, the bump formation operation to the semiconductor wafer 201 is finished. The semiconductor wafer 201 with the bumps 226 formed is transferred and stored as the bump-formed wafer 202 by the transfer device 140 and the carrier 130 into the second storage container.

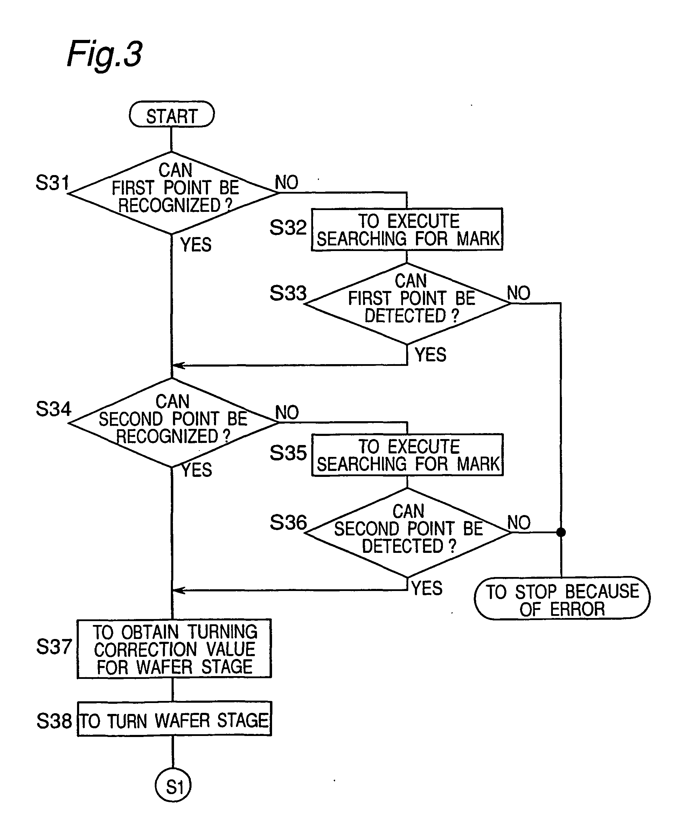

The operation of obtaining information for position correction of the ICs 223 formed on the semiconductor wafer 201 and of correcting the inclination of the ICs 223 (referred to as a "wafer mark recognition operation" hereinafter) which is determined as to whether to be already executed or not in the above-discussed step 3 will now be described with reference to Fig. 3 and the like. The wafer mark recognition operation alike is controlled by the control device 180.

In a process prior to forming bumps with the wafer 201 divided to blocks, if the wafer mark recognition operation is executed when the semiconductor wafer 201 is placed on the wafer stage 1111, the recognition operation for two position recognition marks 224-1 and 224-2 carried out in steps 2 and 4 can be reduced to the recognition for either one mark, so that the productivity is improved furthermore.

This will be more specifically described. A position of the IC formation pattern on the semiconductor wafer with respect to an outline of the semiconductor wafer 201 and an inclination of an arrangement in the row and column directions of ICs 223 forming the IC formation pattern with respect to the reference lines corresponding to the X and Y directions, i.e., the inclination of the ICs are uniform within the same production lot of the semiconductor wafers 201. However, a positional difference and an inclination difference are actually present between two different production lots. As a result, bumps 226 may be positionally deviated to the electrodes 225 if the bump formation is always started from an equal position to the semiconductor wafers 201 of all production lots.

In order to prevent this, the position of the IC formation pattern with respect to the outline of the semiconductor wafer 201 and the inclination of ICs to the reference lines are confirmed when the semiconductor wafer 201 is placed on the wafer stage 1111, thereby eliminating the positional deviation of the bumps 226 to the electrodes 225.

Particularly in the bump forming apparatus 101 of the present embodiment, as described above, the semiconductor wafer 201 is turned with the use of the wafer turning member 111 and the turning device 112 arranged at the heating device 110 via the driving source 1121, the rotational force transmission mechanism 1123, the gear 1122, the threads 11127 of the turntable 1112 and the wafer stage 1111, with the turning angle being controlled by the control device 180, so that the semiconductor wafer 201 can be turned at any angle. In consequence, the wafer stage 1111 loading the semiconductor wafer 201 thereon can be highly accurately and easily turned on the basis of an angle of the inclination of the ICs obtained by the wafer mark recognition operation. The angle of the inclination of the ICs can be highly accurately and easily corrected accordingly.

Since the need of obtaining the angle of the inclination of the ICs through the recognition operation to two position recognition marks 224-1 and 224-2 at the bump formation time is eliminated by correcting the angle of the inclination of the ICs beforehand, it is enough to obtain only position information of the IC formation pattern by the recognition operation to either one of the position recognition marks 224-1 and 224-2. The number of times of the recognition operation can hence be further reduced and the productivity can be improved.

The above wafer mark recognition operation will be described in detail.

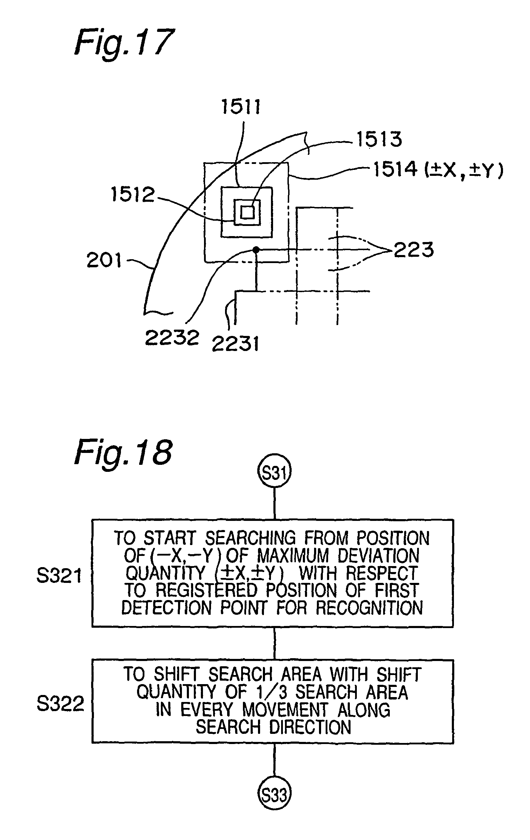

In step 31 shown in Fig. 3, it is determined whether or not a first point among characteristic points on the semiconductor wafer 201 loaded on the wafer stage 1111 is recognized by the image pickup camera 151 of the recognition device 150. In other words, it is necessary for executing the above wafer mark recognition operation to recognize by the image pickup camera 151 two arbitrary detection points for recognition which correspond to marks for detection on the semiconductor wafer 201. A first detection point for recognition among the above two detection points for recognition is set to the control device 180 beforehand. As shown in Fig. 17, according to the embodiment, a corner part in an outline 2231 of the IC formation pattern formed to the circumferential edge part of the semiconductor wafer 201 to which ICs 223 are formed by a stepper is set as the first detection point 2232 for recognition.

The image pickup camera 151 has a view field 1511 as indicated in Fig. 17 having a point to be recognized such as, e.g., the first detection point 2232 for recognition at a center position of the view field. The recognition device 150 can obtain a coordinates position of the point to be recognized if the point to be recognized is included in a cell 1512 for rough recognition inside the view field 1511 and moreover in a cell 1513 for fine recognition in the cell 1512.

In starting the wafer mark recognition operation, the image pickup camera 151 is positioned on the basis of coordinates data of the first detection point 2232 for recognition. However, the first detection point 2232 for recognition is not always included in the view field 1511 when the image pickup camera 151 first images the semiconductor wafer 201 because of a displacement or the like of the semiconductor wafer 201 when loaded on the wafer stage 1111. Therefore, it is determined in step 31 whether or not the first detection point 2232 for recognition can be recognized by the recognition device 150. When the detection point can be recognized, the step moves to next step 34. The step moves to step 32 if the detection point cannot be recognized.

If a true point to be recognized, i.e., the above first detection point 2232 for recognition is present outside a maximum deviation area 1514 defined by four points with coordinates positions of ±x in the X direction and ±y in the Y direction from a center position of the view field 1511 to which the image pickup camera is positioned, it is impossible to recognize the first detection point 2232, necessitating shifting the view field 1511. The maximum deviation area 1514 is a region beyond the view field 1511.

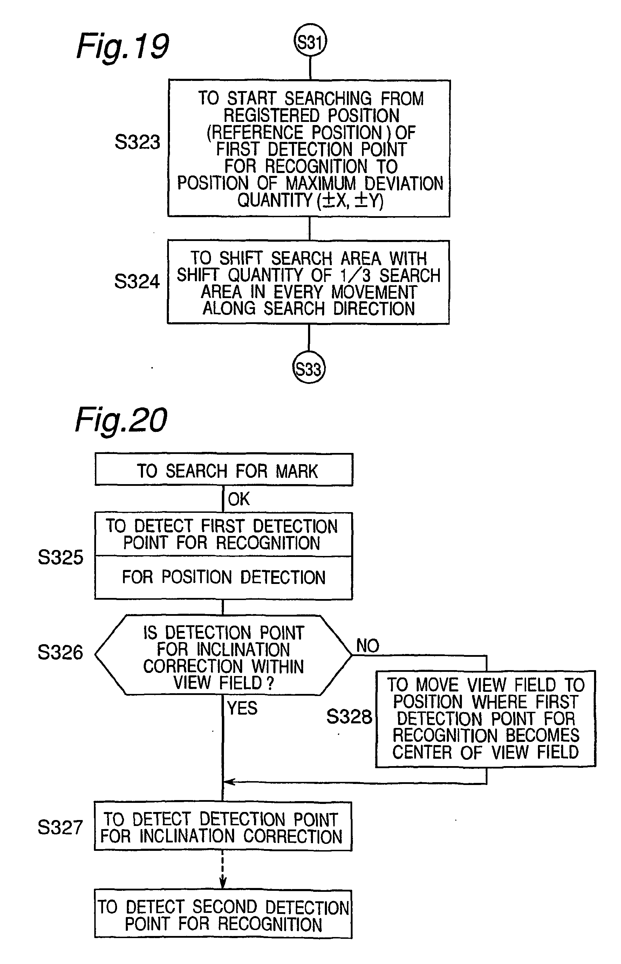

In step 32, one of three operations, that is, operation of searching for the first detection point 2232 shown in Fig. 18 or 19 (steps 321-322 and steps 323-324), operation of searching for the first detection point 2232 and operation of facilitating recognizing a second detection point both of which are shown in Fig. 20 (steps 325-328) is carried out. Each of these operations will be described below.

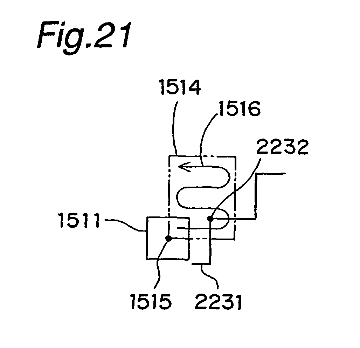

In the search operation for the first detection point 2232 shown in Fig. 18, in step 321, the image pickup camera 151 starts the recognition operation from a search start position 1515 of (-x, -y) which is a coordinates showing one point among four corners defining the maximum deviation area 1514 as shown in Fig. 21 on the basis of the coordinates of the first detection point 2232 registered beforehand in the bump formation program.

As mentioned before, the position of the preliminarily registered first detection point 2232 is normally not coincident with the center position of the view field 1511 because of the displacement or the like of the semiconductor wafer 201 when loaded, as is clearly shown in Fig. 21.

Although the search start position 1515 is set to the coordinates (-x, -y) in the embodiment, the position is not limited to this and may be the other three points of the four corners forming the maximum deviation area 1514.

The first detection point 2232 is searched for in next step 322 while the image pickup camera 151 is moved by every move distance 1517 along the X and Y directions in a serpentine search direction 1516 within the maximum deviation area 1514 from the above search start position 1515, for instance, by a predetermined distance along the X direction, then by a predetermined distance along the Y direction, then by a predetermined distance along the opposite direction to the X direction, by a predetermined distance along the Y direction again and then by a predetermined distance again in the X direction.

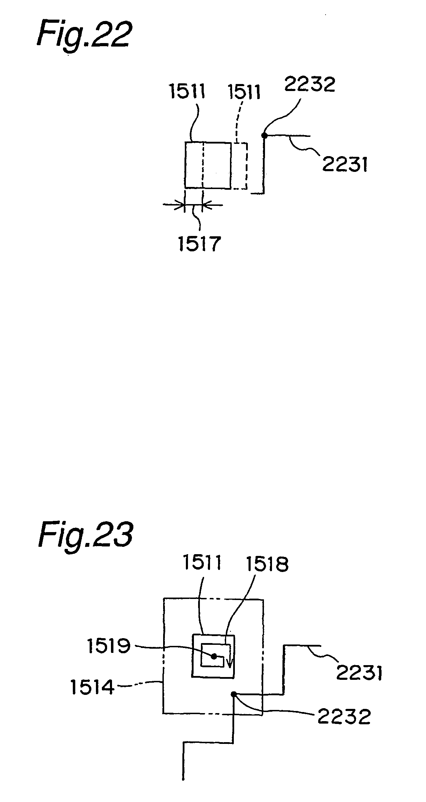

The move distance 1517 is set to be a distance corresponding to 1/3 a length in the X or Y direction of the view field 1511 in the embodiment as indicated in Fig. 22.

The way of moving the image pickup camera 151 in the serpentine fashion facilitates recognizing the search operation and its area and setting the maximum deviation area 1514.

In the search operation in the steps 321, 322, the search start position 1515 for the first detection point 2232 is set to (-x, -y) which is the position coordinates of one point among four points forming the maximum deviation area 1514. Meanwhile, in the search operation for the first detection point 2232 indicated in Fig. 19, a search start position 1519 is set to a coordinates of the center of the view field 1511 to search the inside of the maximum deviation area 1514 in step 323.

In next step 324, as shown in Fig. 23, the first detection point 2232 is searched for while the image pickup camera 151 is moved by the above every move distance 1517 along a search direction 1518 nearly spirally inside the maximum deviation area 1514 from the search start position 1519. The move distance 1517 is set to the distance corresponding to 1/3 the length in the X or Y direction of the view field 1511 in step 324 as well as in step 322.

The above manner of moving the image pickup camera 151 nearly spirally enables the first detection point 2232 to be detected early as compared with the method of moving the image pickup camera in the serpentine way if the first detection point 2232 is highly possibly present in the vicinity of the center of the view field 1511. Moreover, when a region inside the view field 1511 where the first detection point 2232 is highly possibly present is already known, the first detection point 2232 can be detected early by moving the image pickup camera 151 spirally starting from a point within the region of the high possibility.

A combined movement method of the above-described serpentine movement and spiral movement may also be adopted.

The search operation in steps 325-328 will be discussed here, in which the first detection point 2232 is recognized in step 325 based on the search operation of steps 321-322 and steps 323-324.

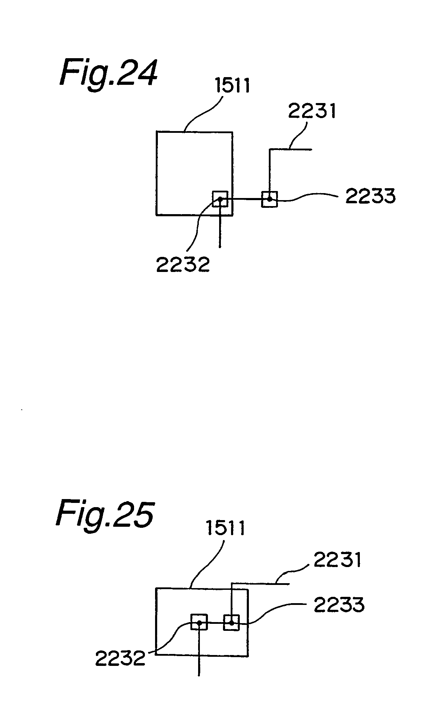

In next step 326, it is determined whether or not a detection point for inclination correction which corresponds to an example of the mark for detection is present inside the view field 1511. The detection point for inclination correction is an arbitrary characteristic point on the semiconductor wafer 201 present inside the view field 1511 having the first detection point 2232 at the center thereof, and is preliminarily registered in the bump formation program. For example, as shown in Fig. 24, a corner part on the outline 2231 of the IC formation pattern which is different from the first detection point 2232 may be set as the detection point 2233 for inclination correction. The detection point 2233 for inclination detection may be an arbitrary shape part in the IC 223 present inside the view field 1511 or a mark for the detection point for inclination correction may be newly formed in the IC 223. Or a mark for the detection point for inclination correction may be formed to a region inside the view field 1511 and outside the outline 231 where an aluminum film is formed.

When the detection point 2233 for inclination correction is determined to be inside the view field 1511 in above step 326, the inclination correction detection point 2233 is detected in step 327 without moving the image pickup camera 151. In contrast, if the inclination correction detection point 2233 is not present in the view field 1511 as in Fig. 24, the step moves to step 328.

In step 328, the image pickup camera 151 is moved to position the first detection point 2232 to the center of the view field 1511 as shown in Fig. 25 because the coordinates position of the first detection point 2232 for recognition is already known. Since the detection point 2233 for inclination correction is set to be present inside the view field 1511 in which the first detection point 2232 is present at the center of the view field 1511 as described hereinabove, the detection point 2233 for inclination correction can be caught within the view field 1511 by the above movement of the image pickup camera 151. Other than by moving the first detection point 2232 to the center of the view field 1511, the image pickup camera 151, namely, the view field 1511 may be sequentially moved to position the first detection point 2232 sequentially to four corner parts of the view field 1511 to catch the detection point 2233.

The step then moves to the aforementioned step 327, where the detection point 2233 for inclination correction is detected.

As above, by preliminarily setting the detection point 2233 for inclination correction inside the view field 1511 centering the first detection point 2232 for recognition, not only the first detection point 2232 for recognition can be recognized, but the detection point 2233 for inclination correction can be recognized. As a result of this, the positional deviation of the ICs 223 formed on the semiconductor wafer 201 can be detected, e.g., on the basis of coordinates information of the first detection point 2232, and moreover, rough information on the angle of the inclination of the ICs 223 formed on the semiconductor wafer 201 can be obtained on the basis of the coordinates information of the first detection point 2232 for recognition and the detection point 2233 for inclination correction. A time necessary for search to be required in recognition operation for the second detection point for recognition to be described later can be shortened or even eliminated.

Since the angle of the inclination can be obtained with a higher accuracy if the inclination is obtained by detecting a position as far as possible from the first detection point 2232, recognizing the second detection point for recognition is carried out in the embodiment as described below. However, the recognition operation for the second detection point for recognition can be saved and the inclination angle obtained with the use of the detection point 2233 for inclination correction may be utilized.

Regarding the detection point 2233 for inclination correction, the corner part in the outline 2231 is set as the detection point 2233 for inclination correction in the present embodiment as above. A shape of the detection point 2233 in the embodiment is accordingly formed of two orthogonal lines. However, the shape is not limited to the above two orthogonal lines and an arbitrary shape, e.g., a circle, a triangle, a square, a cross or the like can be selected.

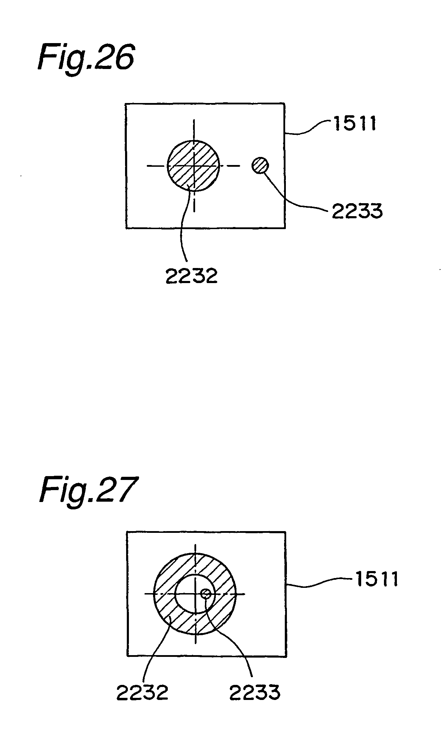

When the shape is other than a circle and if the semiconductor wafer 201 is disposed exceeding, e.g., by ±5° to a normal arrangement position whereby the recognition device 150 cannot determine the inclination difference of the semiconductor wafer 201, it is difficult to recognize the inclination difference. As such, when the inclination over the above ±5° is estimated, the detection point 2233 for inclination correction is preferably made circular, for example, in a form shown in Fig. 26 or 27.

Step 32 is completed by the above operation.

It is determined in following step 33 whether or not the first detection point 2232 for recognition can be detected through the search operation in above step 32. The step moves to next step 34 when the detection point can be detected, whereas an error stop is determined when the detection point cannot be detected and the bump formation process is stopped.

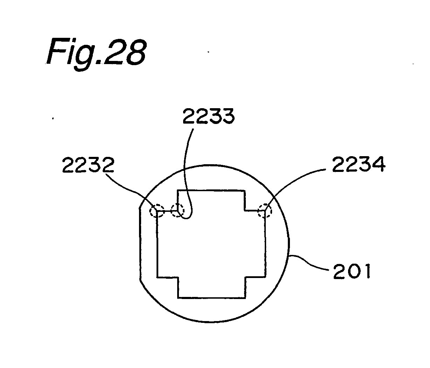

In step 34 similar to above step 31, it is determined whether or not the second detection point for recognition which is a second point of characteristic points on the semiconductor wafer 201 placed on the wafer stage 1111 and corresponds to an example of the mark for detection is recognized by the image pickup camera 151 of the recognition device 150. As shown in Fig. 28, the second detection point 2234 for recognition may be set, e.g., to a corner part on the outline 2231 similar to the first detection point 2232 for recognition.

When the semiconductor wafer 201 is inclined by within the above ±5° in terms of an inclination value of the semiconductor wafer 201, the first detection point 2232 for recognition and the detection point 2233 for inclination correction can be detected by moving the image pickup camera 151 in the X and Y directions. The image pickup camera 151 is then moved towards a position where the second detection point 2234 for recognition is present with the utilization of the rough information on the inclination angle obtained from the position information of the first detection point 2232 for recognition and the detection point 2233 for inclination correction. The second detection point 2234 for recognition is recognized by the same operation as in the above step 32.

On the other hand, if the inclination of the semiconductor wafer 201 is over the above ±5°, the image pickup camera 151 can be moved in a manner as follows towards the position where the second detection point 2234 for recognition is present. Since the heating device 110 has the wafer turning member 111 and the turning device 112, and hence can turn the semiconductor wafer 201 by any angle as described earlier in the embodiment, the semiconductor wafer 201 is roughly positioned by the following operation. Namely, first, the image pickup camera 151 is moved while the wafer stage 1111 with the semiconductor wafer 201 thereon is turned, so that both end parts of an orientation flat of the semiconductor wafer 201 are detected. Then the wafer stage 1111 is turned to a position which corresponds to 1/2 coordinates obtained on the basis of the above obtained position information of the two end parts, whereby the semiconductor wafer 201 is roughly positioned. Thereafter, after recognizing the first detection point 2232 as above, the detection point 2233 for inclination correction is detected as in the description of steps 326-328. The image pickup camera 151 is moved towards the position where the second detection point 2234 is present with the utilization of the rough information on the inclination angle obtained from these position information. The operation of roughly positioning the semiconductor wafer 201 by detecting the orientation flat may be omitted.

The operation similar to step 32 is carried out in next step 35, whereby the second detection point 2234 for recognition is recognized.

By moving the image pickup camera 151 while turning the wafer stage 1111 in the manner as above, a quantity of the move of the image pickup camera 151 can be reduced and the recognition of the detection point 2233 for inclination correction can be sped up.

It is determined in next step 36 whether or not the second detection point 2234 for recognition can be detected by the search operation in above step 35. The step goes to next step 37 when the detection point can be detected. An error stop is determined when the detection point cannot be detected and the bump formation process is brought to a halt.

An angle for turning the wafer stage 1111 is obtained in step 37 on the basis of the coordinates information of the first detection point 2232 for recognition and the second detection point 2234 for recognition obtained in above steps 32, 35.

The control device 180 turns the wafer stage 1111 in following step 38 according to the obtained turning angle. Accordingly, the row and column directions as the arrangement direction of ICs 223 in the IC formation pattern of the semiconductor wafer 201 are agreed with the X and Y directions. The step goes to step 1 described before.

As explained above, before step 1 is executed, the inclination difference of the IC formation pattern is detected and the quantity of the inclination is obtained, and then the semiconductor wafer 201 is turned beforehand in accordance with the quantity of the inclination. The X direction is accordingly agreed with the row direction 221 and the Y direction is agreed with the column direction 222. Thus, since the inclination of the basic block 230 is already corrected at a time when bumps are to be formed, it is enough to recognize only one of two marks 224 for position recognition of the basic block 230. So the recognition operation can be lessened and the productivity can be improved more.

As is detailed herein, according to the bump forming apparatus 101 and the bump formation method of the present embodiment, the number of times of the recognition operation is reduced in comparison with the conventional art, so that the productivity can be improved. For instance when there are 3100 ICs formed on the semiconductor wafer and 8 bumps are to be formed to each IC, conventionally, approximately 80 minutes are required to form bumps if two marks are recognized for each IC. In contrast, the bump formation can be completed in about 38 minutes by executing the operation in above steps 31-38 and forming bumps in units of blocks as depicted above.

The productivity can hence be increased to approximately 1.5-3 times that of the conventional art according to the bump forming apparatus 101 and the bump formation method of the embodiment. In other words, if the productivity is allowed to be an equal level to a level of the conventional art, an installation area of the bump forming apparatus can be reduced to approximately 1/1.5-1/3 an area of the conventional art.

Although the present invention has been fully described in connection with the preferred embodiment thereof with reference to the accompanying drawings, it is to be noted that various changes and modifications are apparent to those skilled in the art. Such changes and modifications are to be understood as included within the scope of the present invention as defined by the appended claims unless they depart therefrom.

## Claims

1. A method for forming bumps to a semiconductor wafer (201), comprising:
defining basic blocks (230) by a number of rows and columns of ICs, whereby the number is stored in a memory (181) of a control device (180), each of the basic blocks (230) having a plurality of ICs (223) adjacent each other in a row or column direction or in row and column directions among ICs arranged in a grid pattern on the semiconductor wafer to be subjected to bump bonding; and
carrying out position recognition with respect to each of the basic blocks for forming bumps,
wherein a number of the ICs for defining the basic block is a value that positional deviations between all electrodes (225) of all ICs in the basic block and all bumps (226) formed on the electrodes are accommodated within an allowable range when the bumps are continuously formed to the electrodes.

2. The bump formation method according to claim 1, further comprising:
after carrying out the position recognition for a first basic block, forming bumps for the first basic block, whereby the bumps are formed continuously for every IC included in the recognized basic block on a basis of the position recognition; and
when the bump formation operation is shifted from the first basic block to a second basic block among the basic blocks, carrying out the position recognition to the second basic block for forming bumps to ICs included in the second basic block.

3. The bump formation method according to claim 1,
wherein the number of the ICs for defining the basic block is determined further based on at least either a position on the semiconductor wafer where bumps are to be formed, or a time passed after start of the bump formation to the semiconductor wafer.

4. The bump formation method according to claim 2,
wherein after forming bumps for a plurality of the recognized basic blocks, when remaining ICs of the number not satisfying the number of ICs for defining the basic block exist, the bump formation and the position recognition to the remaining ICs are carried out for each of the remaining ICs or for a combination of a plurality of remaining ICs until bumps are formed to all of the remaining ICs.

5. The bump formation method according to claim 1,
wherein the position recognition for the basic block is carried out by recognizing two marks for position recognition (224-1, 224-2) present at diagonal positions of the basic block among marks for position recognition applied to each of ICs at both ends of the basic block.

6. The bump formation method according to claim 1,
wherein an inclination of the ICs arranged to the semiconductor wafer with respect to reference lines corresponding to the X and Y directions is detected before the position recognition operation to the basic block, and the position recognition operation to the basic block is carried out by recognizing only one of two marks for position recognition at the position recognition time to the basic block.

7. The bump formation method according to claim 2,
wherein defective IC information showing a defective IC among the ICs included in the basic block is detected when bumps are continuously formed to the ICs.

8. The bump formation method according to claim 7,
wherein bumps are not formed to the defective ICs on the basis of the defective IC information.

9. An apparatus for forming bumps (226) to a semiconductor wafer (201), which comprises:
a bump bonding apparatus (190) for forming the bumps to ICs (223) arranged in a grid pattern on the semiconductor wafer to be subjected to bump bonding;
a recognition device (150) which includes an image pickup camera (151) movable in column and row directions above the semiconductor wafer for imaging marks for detection (224, 2232-2234) on the semiconductor wafer, and detects a position and an inclination of the ICs on the basis of image pickup information of the image pickup camera; and
a control device (180) for defining basic blocks (230) by a number of rows and columns of ICs, whereby the number is stored in a memory (181) of a control device (180), each of the basic blocks (230) having a plurality of ICs adjacent each other in row or column direction or in row and column directions among the ICs arranged in a grid pattern to the semiconductor wafer, for controlling the recognition device to drive so as to recognize positions in units of basic blocks, and for controlling the bump bonding apparatus to drive on the basis of position recognition information obtained by the position recognition so as to continuously form bumps for every IC included in the recognized basic block on a basis of the position recognition,
wherein the control device obtains the number of ICs for constituting one basic block on the basis of an allowance value for positional deviation between electrodes (225) of the ICs and the bumps to be formed on the electrodes.

10. The bump forming apparatus according to claim 9,
wherein the control device further determines the number of ICs for defining the basic block on the basis of at least either a position on the semiconductor wafer where bumps are to be formed or a time passed after start of the bump formation to the semiconductor wafer.

11. The bump forming apparatus according to claim 9,
wherein, after forming bumps for a plurality of the recognized basic blocks along the row or column direction, when remaining ICs of the number not satisfying the number of ICs for defining the basic block exist, the control device carries out the bump formation and the position recognition to the remaining ICs for each of the remaining ICs or for a combination of a plurality of remaining ICs until bumps are formed to all of the remaining ICs.

12. The bump forming apparatus according to claim 9,
wherein the control device carries out the position recognition to the basic block by controlling the recognition device to drive so as to recognize two marks for position recognition (224-1, 224-2) among marks for position recognition applied to each IC of the basic block.

13. The bump forming apparatus according to claim 9, which further comprises:
a wafer turning member (111) onto which the semiconductor wafer (201) to be subjected to bump bonding is loaded and which is turned in a circumferential direction of the loaded semiconductor wafer; and
a turning device (112) for turning the wafer turning member in the circumferential direction by driving control by the control device,
wherein the control device detects an inclination of the ICs arranged on the semiconductor wafer with respect to reference lines corresponding to the X and Y directions before the recognition operation to the basic block by controlling to drive the recognition device, further corrects the inclination by controlling the turning device on the basis of the detected inclination value of the ICs to turn the semiconductor wafer loaded on the wafer turning member, and also controls the recognition device to drive at the position recognition time to the basic block so as to recognize only one of two marks for position recognition.

14. The bump forming apparatus according to claim 9,
wherein the control device controls the recognition device to drive to detect defective IC information showing a defective IC among the ICs arranged on the semiconductor wafer.

15. The bump forming apparatus according to claim 14,
wherein the control device controls operation of the bump bonding apparatus on the basis of the defective IC information so as not to form the bumps onto the defective ICs.

16. The method according to claim 1,
wherein mark for position recognition on the ICs are either position recognition marks applied to the ICs or portions, as a substitute for the position recognition marks, of a circuit pattern on the IC, or one of the position recognition marks and one of the portions.

17. The method according to claim 1,
wherein the position recognition is carried out on a basis of recognizing two marks which are selected from among different two ICs of the basic block,
the different two ICs for selecting the two marks being located in the row or column direction, or an inclined position to the row or column direction.

18. The method according to claim 1, further comprising:
based on the positional recognition of each of the basic blocks, continuously forming bumps on the ICs defining each of the basic blocks; and
determining whether or not the number of counts that a mark for position recognition cannot be recognized is n or less, and then stopping the operation of forming bumps when the number of counts exceeds said n.

## Patentansprüche

1. Verfahren zum Ausbilden von Kontaktierungsstellen auf einem Halbleiter-Wafer (201), wobei das Verfahren die Schritte enthält:
Festlegen von Grundblöcken (230) durch eine Anzahl von Zeilen und Spalten von ICs, wobei die Anzahl in einem Speicher (181) eines Steuerungsgerätes (180) gespeichert ist, wobei jeder der Grundblöcke (230) eine Vielzahl von ICs (223) besitzt, wobei die ICs, die in einem Raster auf dem Halbleiter-Wafer angeordnet sind, an einander in einer Zeilen- oder Spaltenrichtung oder in Zeilen- und Spaltenrichtungen anschließen, um einem Kontaktierungsstellen-Bonding ausgesetzt zu werden; und
Durchführen einer Positionserkennung hinsichtlich jedem der Grundblöcke zum Ausbilden von Kontaktierungsstellen,
wobei eine Anzahl der ICs zum Festlegen des Grundblocks einen Wert einnimmt, so dass Positionsabweichungen zwischen allen Elektroden (225) aller ICs in dem Grundblock und allen Kontaktierungsstellen (226), die auf den Elektroden ausgebildet werden, innerhalb eines zulässigen Bereichs liegen, wenn die Kontaktierungsstellen kontinuierlich auf den Elektroden ausgebildet werden.

2. Verfahren zum Ausbilden von Kontaktierungsstellen nach Anspruch 1, das ferner die Schritte enthält:
nach dem Durchführen der Positionserkennung für einen ersten Grundblock Ausbilden von Kontaktierungsstellen für den ersten Grundblock, wobei die Kontaktierungsstellen kontinuierlich für jeden IC ausgebildet werden, der in dem erkannten Grundblock auf einer Grundlage der Positionserkennung beinhaltet ist; und
wenn der Vorgang zur Ausbildung der Kontaktierungsstellen von dem ersten Grundblock auf einen zweiten Grundblock zwischen den Grundblöcken verlagert wird, Durchführen der Positionserkennung auf den zweiten Grundblock zum Ausbilden von Kontaktierungsstellen auf ICs, die in dem zweiten Grundblock beinhaltet sind.

3. Verfahren zum Ausbilden von Kontaktierungsstellen nach Anspruch 1,
wobei die Anzahl der ICs zum Festlegen des Grundblocks ferner bestimmt wird basierend auf wenigstens entweder einer Position auf dem Halbleiter-Wafer, wo Kontaktierungsstellen ausgebildet werden sollen, oder einer Zeit, die nach dem Start der Ausbildung der Kontaktierungsstellen auf dem Halbleiter-Wafer vergangen ist.

4. Verfahren zum Ausbilden von Kontaktierungsstellen nach Anspruch 2,
wobei nach dem Ausbilden der Kontaktierungsstellen für eine Vielzahl der erkannten Grundblöcke, wenn verbleibende ICs in der Anzahl existieren, die nicht die Anzahl der ICs zum Festlegen des Grundblocks erfüllt, die Ausbildung der Kontaktierungsstellen und die Positionserkennung für die verbleibenden ICs für jeden der verbleibenden ICs oder für eine Kombination aus einer Vielzahl der verbleibenden ICs durchgeführt werden, bis die Kontaktierungsstellen für alle der verbleibenden ICs ausgebildet sind.

5. Verfahren zum Ausbilden von Kontaktierungsstellen nach Anspruch 1,
wobei die Positionserkennung für den Grundblock durch Erkennen zweier Markierungen für die Positionserkennung (224-1, 224-2), die auf diagonalen Positionen des Grundblocks vorhanden sind, zwischen Markierungen für die Positionserkennung, die auf jeden der ICs an beiden Enden des Grundblocks angewendet werden, durchgeführt wird.

6. Verfahren zum Ausbilden von Kontaktierungsstellen nach Anspruch 1,
wobei eine Verstellung der ICs, die auf dem Halbleiter-Wafer angeordnet sind, hinsichtlich von Referenzlinien, die den X- und Y-Richtungen entsprechen, vor dem Positionserkennungsvorgang auf den Grundblock festgestellt wird und der Positionserkennungsvorgang auf den Grundblock durch Erkennen von lediglich einer von zwei Markierungen für die Positionserkennung zu der Positionserkennungszeit auf dem Grundblock durchgeführt wird.

7. Verfahren zum Ausbilden von Kontaktierungsstellen nach Anspruch 2,
wobei Unbrauchbare-IC-Information, die einen unbrauchbaren IC zwischen den ICs anzeigt, die in einem Grundblock beinhaltet sind, festgestellt wird, wenn Kontaktierungsstellen kontinuierlich auf den ICs ausgebildet werden.

8. Verfahren zum Ausbilden von Kontaktierungsstellen nach Anspruch 7,
wobei Kontaktierungsstellen nicht auf den unbrauchbaren ICs auf der Grundlage der Unbrauchbare-IC-Information ausgebildet werden.

9. Vorrichtung zum Ausbilden von Kontaktierungsstellen (226) auf einem Halbleiter-Wafer (201), welche enthält:
eine Kontaktierungsstellen-Bonding-Vorrichtung (190) zum Ausbilden der Kontaktierungsstellen auf ICs (223), die in einem Raster auf dem Halbleiter-Wafer angeordnet sind, um einem Kontaktierungsstellen-Bonding ausgesetzt zu werden;
ein Erkennungsgerät (150), welches eine oberhalb des Halbleiter-Wafers in Spalten- und Zeilenrichtungen bewegliche Bildaufnahmekamera (151) zum Abbilden von Markierungen zur Erkennung (224, 2232-2234) auf dem Halbleiter-Wafer beinhaltet und eine Position und eine Verstellung der ICs auf der Grundlage von Bildaufnahmeinformation der Bildaufnahmekamera feststellt; und
ein Steuerungsgerät (180) zum Festlegen von Grundblöcken (230) durch eine Anzahl von Zeilen und Spalten von ICs, wobei die Anzahl in einem Speicher (181) eines Steuerungsgeräts (180) gespeichert ist, wobei jeder der Grundblöcke (230) eine Vielzahl von ICs (223) besitzt, wobei die ICs, die in einem Raster auf dem Halbleiter-Wafer angeordnet sind, an einander in einer Zeilen- oder Spaltenrichtung oder in Zeilen- und Spaltenrichtungen anschließen, zum Steuern des Erkennungsgerätes, um es so zu betreiben, Positionen in Einheiten der Grundblöcke zu erkennen, und zum Steuern der Kontaktierungsstellen-Bonding-Vorrichtung, um sie auf der Grundlage der Positionserkennungsinformation, die durch die Positionserkennung erhalten wurde, so zu betreiben, kontinuierlich Kontaktierungsstellen für jeden IC auszuformen, der in dem erkannten Grundblock auf einer Grundlage der Positionserkennung beinhaltet ist,
wobei das Steuerungsgerät die Anzahl der ICs zum Festlegen eines Grundblocks auf der Grundlage eines Zulässigkeitswertes für Positionsabweichung zwischen Elektroden (225) der ICs und der Kontaktierungsstellen erhält, die auf den Elektroden ausgebildet werden sollen.

10. Vorrichtung zum Ausbilden von Kontaktierungsstellen nach Anspruch 9,
wobei das Steuerungsgerät ferner die Anzahl der ICs zum Festlegen des Grundblocks bestimmt auf der Grundlage von wenigstens entweder einer Position auf dem Halbleiter-Wafer, wo Kontaktierungsstellen ausgebildet werden sollen, oder einer Zeit, die nach dem Start der Ausbildung der Kontaktierungsstellen auf dem Halbleiter-Wafer vergangen ist.

11. Vorrichtung zum Ausbilden von Kontaktierungsstellen nach Anspruch 9,
wobei nach dem Ausbilden der Kontaktierungsstellen für eine Vielzahl der erkannten Grundblöcke entlang der Zeilen- oder Spaltenrichtung, wenn verbleibende ICs in der Anzahl existieren, die nicht die Anzahl der ICs zum Festlegen des Grundblocks erfüllt, das Steuerungsgerät die Ausbildung der Kontaktierungsstellen und die Positionserkennung für die verbleibenden ICs für jeden der verbleibenden ICs oder für eine Kombination aus einer Vielzahl der verbleibenden ICs durchführt, bis für alle der verbleibenden ICs Kontaktierungsstellen ausgebildet sind.

12. Vorrichtung zum Ausbilden von Kontaktierungsstellen nach Anspruch 9,
wobei das Steuerungsgerät die Positionserkennung für den Grundblock durchführt durch Steuern des Erkennungsgerätes, um es so zu betreiben, zwei Markierungen für die Positionserkennung (224-1, 224-2) zwischen Markierungen für die Positionserkennung zu erkennen, die auf jeden IC des Grundblocks angewendet werden.

13. Vorrichtung zum Ausbilden von Kontaktierungsstellen nach Anspruch 9, welcher ferner enthält:
ein Wafer-Drehungs-Element (111), auf welchem der Halbleiter-Wafer (201), der einem Kontaktierungsstellen-Bonding ausgesetzt wird, geladen ist und welcher in einer umlaufenden Richtung des geladenen Halbleiter-Wafers gedreht wird; und
ein Drehungsgerät (112) zum Drehen des Wafer-Drehungs-Elements in einer umlaufenden Richtung durch Antriebssteuerung durch das Steuerungsgerät,
wobei das Steuerungsgerät eine Verstellung der ICs, die auf dem Halbleiter-Wafer angeordnet sind, hinsichtlich Referenzlinien, die den X- und Y-Richtungen entsprechen, feststellt vor dem Erkennungsvorgang auf dem Grundblock durch Steuern, das Erkennungsgerät zu betreiben, ferner die Verstellung durch Steuern des Drehungsgerätes auf der Grundlage des erkannten Verstellungswertes der ICs korrigiert, um den Halbleiter-Wafer zu drehen, der auf dem Wafer-Drehungs-Element geladen ist, und auch das Erkennungsgerät steuert, um es zu der Positionserkennungszeit auf dem Grundblock so zu betreiben, um lediglich eine von zwei Markierungen für die Positionserkennung zu erkennen.

14. Vorrichtung zum Ausbilden von Kontaktierungsstellen nach Anspruch 9,
wobei das Steuerungsgerät das Erkennungsgerät steuert, um es zu betreiben, Unbrauchbare-IC-Information, die einen unbrauchbaren IC zwischen den ICs anzeigt, die auf dem Halbleiter-Wafer beinhaltet sind, festzustellen.

15. Vorrichtung zum Ausbilden von Kontaktierungsstellen nach Anspruch 14,
wobei das Steuerungsgerät den Vorgang der Vorrichtung zum Ausbilden von Kontaktierungsstellen auf der Grundlage der Unbrauchbare-IC-Information so steuert, um keine Kontaktierungsstellen auf den unbrauchbaren ICs auszubilden.

16. Verfahren nach Anspruch 1,
wobei Markierungen für die Positionserkennung auf den ICs entweder Positionserkennungsmarkierungen sind, die auf den ICs angebracht sind, oder Teilbereiche einer Schaltungsstruktur auf dem IC als ein Ersatz für die Positionserkennungsmarkierungen oder eine der Positionserkennungsmarkierungen und einer der Teilbereiche.

17. Verfahren nach Anspruch 1,
wobei die Positionserkennung auf einer Grundlage des Erkennens zweier Markierungen durchgeführt wird, welche aus zwei unterschiedlichen ICs des Grundblocks ausgewählt werden,
wobei die zwei unterschiedlichen ICs zum Auswählen der zwei Markierungen in der Zeilen- oder Spaltenrichtung oder einer zu der Zeilen- oder Spaltenrichtung verstellten Position angeordnet sind.

18. Verfahren nach Anspruch 1, das ferner enthält:
basierend auf der Positionserkennung jedes der Grundblöcke ein kontinuierliches Ausbilden von Kontaktierungsstellen auf den ICs, die jeden der Grundblöcke festlegen; und
Bestimmen, ob die Anzahl der Zählungen, dass eine Markierung für die Positionserkennung nicht erkannt werden kann, n ist oder weniger, oder nicht und dann Anhalten des Vorgangs des Ausbildens von Kontaktierungsstellen, wenn die Anzahl der Zählungen n übersteigt.

## Revendications

1. Procédé de formation de bossages sur une plaquette semi-conductrice (201), comprenant:
définir des blocs basiques (230) par un nombre de lignes et de colonnes d'ICs, de sorte que le nombre soit stocké dans une mémoire (181) d'un dispositif de commande (180), chacun des blocs basiques (230) ayant une pluralité d'ICs (223) adjacentes les unes aux autres dans une direction de ligne ou de colonne ou dans des directions de lignes ou de colonnes parmi les ICs disposées dans un motif de grille sur la plaquette semi-conductrice à soumettre à une liaison par bossages; et
exécuter une reconnaissance de position par rapport à chacun des blocs basiques pour former des bossages,
où un nombre des ICs pour définir le bloc basique est une valeur où des déviations de positions entre toutes les électrodes (225) de toutes les ICs dans le bloc basique et tous les bossages (226) formés sur les électrodes sont contenues dans une gamme admissible lorsque les bossages sont continuellement formés aux électrodes.

2. Procédé de formation de bossages selon la revendication 1, comprenant en plus:
après l'exécution de la reconnaissance de position pour un premier bloc basique, former des bossages pour le premier block basique, de sorte que les bossages soient formés continuellement pour chaque IC incluse dans le bloc basique reconnu sur la base de la reconnaissance de position; et
lorsque l'opération de formation de bossages passe du premier bloc basique à un deuxième bloc basique parmi les blocs basiques, exécuter la reconnaissance de position au deuxième bloc basique pour former des bossages à des ICs incluses dans le deuxième bloc basique.

3. Procédé de formation de bossages selon la revendication 1,
dans lequel le nombre des ICs pour définir le bloc basique est en plus déterminé sur la base d'au moins soit une position sur la plaquettes semi-conductrice où des bossages doivent être formés, ou un temps passé après le début de la formation de bossages à la plaquette semi-conductrice.

4. Procédé de formation de bossages selon la revendication 2,
dans lequel après la formation de bossages pour une pluralité des blocs basiques reconnus, lorsque des ICs restantes du nombre qui ne satisfait pas le nombre d'ICs pour définir le bloc basique existent, la formation de bossages et la reconnaissance de positions aux ICs restantes sont exécutés pour chacune des ICs restantes ou pour une combinaison d'une pluralité d'ICs restantes jusqu'à ce que des bossages soient formées à toutes les ICs restantes.

5. Procédé de formation de bossages selon la revendication 1,
dans lequel la reconnaissance de position pour le bloc basique est exécutée en reconnaissant deux repères pour la reconnaissance de position (224-1, 224-2) présents à des positions diagonales du bloc basique parmi des repères pour la reconnaissance de position appliqués à chacune des ICs aux deux extrémités du bloc basique.

6. Procédé de formation de bossages selon la revendication 1,
dans lequel une inclinaison des ICs disposées sur la plaquette semi-conductrice par rapport à des lignes de référence correspondant aux directions X et Y est détectée avant l'opération de reconnaissance de position au bloc basique, et l'opération de reconnaissance de position au bloc basique est exécutée en reconnaissant uniquement une de deux repères pour la reconnaissance de position au temps de reconnaissance de position au bloc basique.

7. Procédé de formation de bossages selon la revendication 2,
dans lequel une information d'IC défectueuse montrant une IC défectueuse parmi les ICs incluses dans le bloc basique est détectée lorsque des bossages sont formés continuellement sur les ICs.

8. Procédé de formation de bossages selon la revendication 7,
dans lequel des bossages ne sont pas formés sur les ICs défectueuses sur la base de l'information d'IC défectueuse.

9. Appareil pour former des bossages (226) sur une plaquette semi-conductrice (201), qui comprend:
un appareil de liaison par bossages (190) pour former les bossages sur des ICs (223) disposées dans un motif de grille sur la plaquette semi-conductrice à soumettre à la liaison par bossages;
un dispositif de reconnaissance (150) qui inclut une caméra de prise d'image (151) mobile dans des directions de colonnes et de lignes au-dessus de la plaquettes semi-conductrice pour prendre des images de repères pour la détection (224, 2232-2234) sur la plaquette semi-conductrice, et détecte une position et une inclinaison des ICs sur la base d'une information de prise d'image de la caméra de prise d'image; et
un dispositif de commande (180) pour définir des blocs basiques (230) par un nombre de lignes et de colonnes d'ICs, de sorte que le nombre soit stocké dans une mémoire (181) d'un dispositif de commande (180), chacun des blocs basiques (230) ayant une pluralité d'ICs (223) adjacentes les unes aux autres dans une direction de ligne ou de colonne ou dans des directions de ligne et de colonne parmi les ICs disposées dans un motif de grille sur la plaquette semi-conductrice, pour commander le dispositif de reconnaissance à piloter afin de reconnaître des positions en unités de blocs basiques, et pour commander l'appareil de liaison par bossages à piloter sur la base d'information de reconnaissance de position obtenue par la reconnaissance de position de façon à former continuellement des bossages pour chaque IC incluse dans le bloc basique reconnu sur la base de la reconnaissance de position,
dans lequel le dispositif de commande obtient le nombre d'ICs pour constituer un bloc basique sur la base d'une valeur de tolérance pour une déviation de positions entre des électrodes (225) des ICs et les bossages à former sur les électrodes.

10. Appareil de formation de bossages selon la revendication 9,
dans lequel le dispositif de commande détermine en plus le nombre d'ICs pour définir la bloc basique sur la base d'au moins soit une position sur la plaquette semi-conductrice où des bossages doivent être formés soit un temps passé après le début de la formation de bossages sur la plaquette semi-conductrice.

11. Appareil de formation de bossages selon la revendication 9,
dans lequel, après la formation de bossages pour une pluralité des blocs basiques reconnus le long de la direction de ligne ou de colonne, lorsque des ICs restantes du nombre ne satisfaisant pas le nombre d'ICs pour définir le bloc basique existent, le dispositif de commande exécute la formation de bossages et la reconnaissance de position aux ICs restantes pour chacune des ICs restantes ou pour une combinaison d'une pluralité d'ICs restantes jusqu'à ce que des bossages soient formés à toutes les ICs restantes.

12. Appareil de formation de bossages selon la revendication 9,
dans lequel le dispositif de commande exécute la reconnaissance de position au bloc basique en commandant le dispositif de reconnaissance à piloter afin de reconnaître deux repères pour la reconnaissance de position (224-1, 224-2) parmi des repères pour la reconnaissance de position appliqués à chaque IC du bloc basique.

13. Appareil de formation de bossages selon la revendication 9, qui comprend en plus:
un organe de retournement de plaquette (111) sur lequel la plaquette semi-conductrice (201) qui sera soumise à une liaison par bossages est chargée et qui est retourné dans une direction circonférentielle de la plaquette semi-conductrice chargée; et
un dispositif de retournement (112) pour retourner l'organe de retournement de plaquette dans la direction circonférentielle par le biais d'une commande de pilotage par le dispositif de commande,
où le dispositif de commande détecte une inclinaison des ICs disposées sur la plaquette semi-conductrice par rapport à des lignes de référence correspondant aux direction X et Y avant l'opération de reconnaissance au bloc basique en commandant le pilotage du dispositif de reconnaissance, corrige en outre l'inclinaison en commandant le dispositif de retournement sur la base de la valeur d'inclinaison détectée des ICs pour retourner la plaquette semi-conductrice chargée sur l'organe de retournement de plaquette, et commande également le dispositif de reconnaissance pour le piloter au temps de reconnaissance de position au bloc basique de façon à ne reconnaître qu'un seul parmi deux repères pour la reconnaissance de position.

14. Appareil de formation de bossages selon la revendication 9,
dans lequel le dispositif de commande effectue une commande du dispositif de reconnaissance de façon à le piloter en vue de détecter une information d'IC défectueuse montrant une IC défectueuse parmi les ICs disposées sur la plaquette semi-conductrice.

15. Appareil de formation de bossages selon la revendication 14,
dans lequel le dispositif de commande effectue une commande un fonctionnement de l'appareil de liaison par bossages sur la base de l'information d'IC défectueuse afin de ne pas former les bossages sur les ICs défectueuses.

16. Procédé selon la revendication 1,
dans lequel des repères pour la reconnaissance de position sur les ICs sont soit des repères de reconnaissance de position appliqués aux ICs soit des parties, comme un substitut aux repères de reconnaissance de position, d'un motif de circuit sur l'IC, ou l'un des repères de reconnaissance de position et l'une des parties.

17. Procédé selon la revendication 1,
dans lequel la reconnaissance de position est exécutée sur la base de la reconnaissance de deux repères qui sont sélectionnés parmi deux ICs différentes du bloc basique,
les deux ICs différentes pour sélectionner les deux repères étant situées dans la direction de ligne ou de colonne, ou une position inclinée par rapport à la direction de ligne ou de colonne.

18. Procédé selon la revendication 1, comprenant en plus:
selon la reconnaissance de position de chacun des blocs basiques, former continuellement des bossages sur les ICs définissant chacun des blocs basiques; et
déterminer si le nombre de décomptes où un repère de reconnaissance de position ne peut pas être reconnu est n ou moins, et ensuite arrêter l'opération de formation de bossages lorsque le nombre de décomptes dépasse ledit n.
